# EUROPEAN PATENT SPECIFICATION

(11) **EP 4 550 952 B1**
(45) Date of publication and mention of the grant of the patent: **15.07.2026**
(21) Application number: 23831016.3
(22) Date of filing: 08.06.2023
(51) Int. Cl.: H10W 70/685, H05K 1/03, H05K 1/16, H05K 3/46, H10P 54/00, H10W 70/692, H10W 70/60, H10P 72/70, H10W 44/20

(54) **GLASS CORE LAMINATE STRUCTURE AND PRODUCTION METHOD FOR GLASS CORE LAMINATE STRUCTURE**
GLASKERNLAMINATSTRUKTUR UND HERSTELLUNGSVERFAHREN FÜR EINE GLASKERNLAMINATSTRUKTUR
STRUCTURE STRATIFIÉE À NOYAU DE VERRE ET SON PROCÉDÉ DE PRODUCTION

(30) Priority: 01.07.2022 JP 2022106924; 27.12.2022 JP 2022209893
(43) Date of publication of application: 07.05.2025
(73) Proprietor: Toppan Holdings Inc., Tokyo 110-0016 (JP)
(72) Inventor: SAWADAISHI, Masashi, Tokyo 110-0016 (JP)
(74) Representative: Plasseraud IP
(86) International application number: PCT/JP2023/021314
(87) International publication number: WO 2024/004566

(56) References cited:
- JP-B1- 7 067 666
- JP-B1- 7 067 666
- US-A1- 2014 015 121
- US-A1- 2015 129 293
- US-A1- 2016 135 289
- US-A1- 2020 357 734

## Description

### [Technical Field]

The present invention relates to a glass core laminate structure, and a production method for a glass core laminate structure.

### [Background Art]

As electronic devices become more sophisticated and smaller in size, there is an increasing need for higher density wiring substrates that constitute semiconductor devices. Accordingly, as circuit wiring becomes finer, there is also a need for smaller passive components such as resistors, capacitors, and inductors. However, there is a limit to how much size reduction can be achieved by simply reducing the size and mounting such passive components with a high density on the substrate surface. Therefore, a technique that embeds passive elements into a mounting substrate has been proposed (for example, see PTL 1).

In this technique, passive elements are embedded into the interior of a multilayered substrate by forming them using printing, vacuum film formation, or the like. Further, in addition to reducing the size, a shorter wiring length has the effect of reducing high frequency noise.

On the other hand, organic materials such as glass epoxy resins are generally used as the material of wiring substrates. Recent advances in drilling technology for glass materials have made it possible, for example, to form small-diameter through-holes of 100 µm or less at a pitch of 150 µm or less in a 300 µm-thick glass substrate.

For this reason, glass is attracting attention as a material for electronic circuit substrates.

A circuit substrate using a glass material as the core substrate (hereinafter referred to as a "glass circuit substrate") has high mounting reliability because the coefficient of linear thermal expansion (CTE) of glass is small, ranging from 2 ppm to 8 ppm, and matches the CTE of silicon chips. Furthermore, the superior flatness enables high-precision mounting, which also has a positive effect on the ability to form fine wiring and perform high-speed transmission.

### [Citation List]

### [Patent Literature]

PTL 1: JP 2000-151114 A
PTL 2: US 2014/0015121 A1 discloses a wiring substrate in which a core substrate is cut with a cutting device, so that resin filled in openings remains on side surfaces of the core substrate and covers the side surface.

### [Summary of the Invention]

### [Technical Problem]

However, the following problems can arise when a capacitor is formed within the glass circuit substrate described above.

When a glass substrate is used as a core substrate, and an attempt is made to form a multilayer wiring substrate by forming wiring layers on the upper and lower surfaces of the glass substrate, microcracks can sometimes occur in the glass substrate due to the stress of the wiring layers when performing singulation of the multilayer wiring substrate from a base material substrate. Such microcracks (hereinafter, also referred to as "µ-cracks") cause a phenomenon in which a breakage occurs in the glass substrate. For this reason, it has been difficult to ensure the reliability of a multilayer wiring substrate that uses a glass material as a core substrate.

Furthermore, singulation of a multilayer wiring substrate that uses a glass material as a core substrate is performed by a grinding process. Very fine cracks occur in the end surfaces of the glass substrate upon singulation by a grinding process, and the stress generated due to a difference in the linear expansion coefficient of the glass substrate and the wiring layers results in the growth of very fine cracks, causing the glass substrate to split and generate µ-cracks. The occurrence of µ-cracks becomes prominent due to the accumulation of stress, particularly when there is a large difference in the linear expansion coefficient of the glass substrate and the wiring layers, and also due to temperature changes, particularly during temperature cycling tests.

The µ-cracks are a phenomenon that occurs due to the very fine cracks that occur in the end surfaces of the glass substrates upon singulation, as well as due to the stress caused by a difference in the linear expansion coefficient of the glass substrate and the wiring layers. Therefore, if the wiring layers of the multilayer wiring substrate described above are structures made of a material having a linear expansion coefficient difference with the glass substrate, µ-cracks can occur because of the generation of stress. For example, even if the structure has a layer consisting of only a conductive material, a layer consisting of only a resin material, or a layer consisting of a mixture of these, if the structure is made of a material that has a linear expansion coefficient difference with the glass substrate, there is a concern that µ-cracks may occur because of the generation of stress.

Furthermore, because such a phenomenon occurs due to a linear expansion coefficient difference with the glass substrate, even in the case of a single layer structure rather than a multilayer structure, there is a concern that stress will be generated, causing µ-cracks to occur. In the case of a multilayer structure, because the accumulated stress is greater than that of a single layer structure, the occurrence of µ-cracks becomes more pronounced.

As a result of the above, the occurrence of µ-cracks is a significant problem in glass core laminate structures in which a structure having a linear expansion coefficient difference with a glass substrate is laminated on the glass substrate.

Therefore, an object of the present invention is to provide a technique that makes it possible to avoid the occurrence of damage to a core substrate, and ensure the reliability of a glass core laminate structure and a wiring substrate.

### [Solution to Problem]

In order to solve the above problem, a representative glass core laminate structure of the present invention includes: a glass core substrate having a first surface, and a second surface opposing the first surface; and a laminate including, above the first surface and below the second surface, a layer formed of a material different from that of the glass core substrate; wherein a side surface of the glass core laminate structure is covered with the same material as one material forming the laminate, and a plurality of recessed portions having a substantially rectangular shape, through which a plurality of vertical ridge lines and horizontal ridge lines can be visually recognized, are formed on at least a portion of the side surface of the glass core substrate.

### [Advantageous Effects of the Invention]

According to the present invention, it is possible to avoid the occurrence of damage to a core substrate, and to ensure the reliability of a glass core laminate structure and a wiring substrate. The problems, configurations and effects other than those described above will become apparent from the description of the following embodiments.

### [Brief Description of the Drawings]

Fig. 1 is a cross-sectional view showing a multilayer wiring substrate according to a first embodiment.
Fig. 2 is a cross-sectional view showing the structure of a through electrode within the multilayer wiring substrate according to the first embodiment.
Fig. 3 is a cross-sectional view illustrating an adhesion step of a first support body in a production method according to the first embodiment.
Fig. 4 is a cross-sectional view illustrating a formation step of laser modified portions in the production method according to the first embodiment.
Fig. 5 is a diagram illustrating locations in which laser modified portions are formed in the production method according to the first embodiment.
Fig. 6 is a cross-sectional view illustrating a formation step of a first wiring layer in the production method according to the first embodiment.
Fig. 7 is a cross-sectional view illustrating an adhesion step of a second support body in the production method according to the first embodiment.
Fig. 8 is a cross-sectional view illustrating a detachment step of the first support body in the production method according to the first embodiment.
Fig. 9A is a cross-sectional view illustrating a formation step of through holes by etching in the production method according to the first embodiment.
Fig. 9B is a bottom view showing a case where a separation groove is formed.
Fig. 9C is a diagram schematically showing enlarged a portion of the bottom view of the separation groove.
Fig. 9D is a diagram schematically showing a side surface of the separation groove.
Fig. 9E is a diagram schematically showing enlarged the separation groove.
Fig. 9F is a diagram schematically showing enlarged a portion of the bottom view of the separation groove.
Fig. 10 is a cross-sectional view illustrating a formation step of a second wiring layer in the production method according to the first embodiment.
Fig. 11 is a cross-sectional view illustrating a detachment step of the second support body in the production method according to the first embodiment.
Fig. 12 is a cross-sectional view showing a state after the detachment step of the second support body has been performed in the production method according to the first embodiment.
Fig. 13 is a cross-sectional view illustrating a formation step of a build-up layer in the production method according to the first embodiment.
Fig. 14 is a cross-sectional view illustrating a formation step of connection pads in the production method according to the first embodiment.
Fig. 15 is a cross-sectional view illustrating a singulation step in the production method according to the first embodiment.
Fig. 16 is a diagram showing a flowchart of the production method according to the first embodiment.
Fig. 17 is a cross-sectional view illustrating a formation step of a first wiring layer in a production method according to a first modification.
Fig. 18 is a cross-sectional view illustrating a formation step of laser modified portions in the production method according to the first modification.
Fig. 19 is a diagram showing a flowchart of the production method according to the first modification.
Fig. 20 is a cross-sectional view illustrating an adhesion step of a second support body in a production method according to a second modification.
Fig. 21 is a cross-sectional view illustrating a formation step of laser modified portions in the production method according to the second modification.
Fig. 22 is a diagram showing a flowchart of the production method according to the second modification.
Fig. 23 is a diagram illustrating an overlap ratio of a laser modified portion and a through hole.
Fig. 24 is a cross-sectional view showing a multilayer wiring substrate according to the second embodiment.

### [Description of the Embodiments]

Some embodiments of the present invention will be described below with reference to the drawings.

It should be noted that the description below relates to examples of the present invention, and the present invention is not limited by these examples. Furthermore, in the description of the drawings, like parts are indicated with like reference signs.

The position, size, shape, range, and the like, of each component shown in the drawings may not represent the actual position, size, shape, and range in order to facilitate understanding of the invention. Therefore, the present invention is not necessarily limited to the positions, sizes, shapes and ranges disclosed in the drawings.

Note that, in the present disclosure, the term "surface" may refer not only to the surface of a plate-shaped member, but also to an interface of a layer contained in a plate-shaped member that is substantially parallel to a surface of the plate-shaped member. Furthermore, the terms "upper surface" and "lower surface" refer to the surfaces shown in the upper and lower directions in the drawings when a plate-shaped member or a layer included in a plate-shaped member is illustrated. The "upper surface" and "lower surface" may also be referred to as a "first surface" and a "second surface" respectively.

Furthermore, the term "side surface" refers to a surface of a plate-shaped member or a layer included in the plate-shaped member and refers to a surface in a thickness direction. In addition, a portion of a surface and a side surface may be collectively referred to as an "edge portion".

Also, the term "above" refers to the vertically upper direction when a plate-shaped member or layer is placed horizontally. Further, the term "above" and its opposite term "below" may sometimes be referred to as the "positive Z-axis direction" and "negative Z-axis direction", and the horizontal directions are sometimes referred to as the "X-axis direction" and "Y-axis direction".

Moreover, the term "bottom portion" may sometimes refer to a location that is in a perpendicular direction to the paper surface in the drawings.

### <First Embodiment>

### (Structure of Multilayer Wiring Substrate)

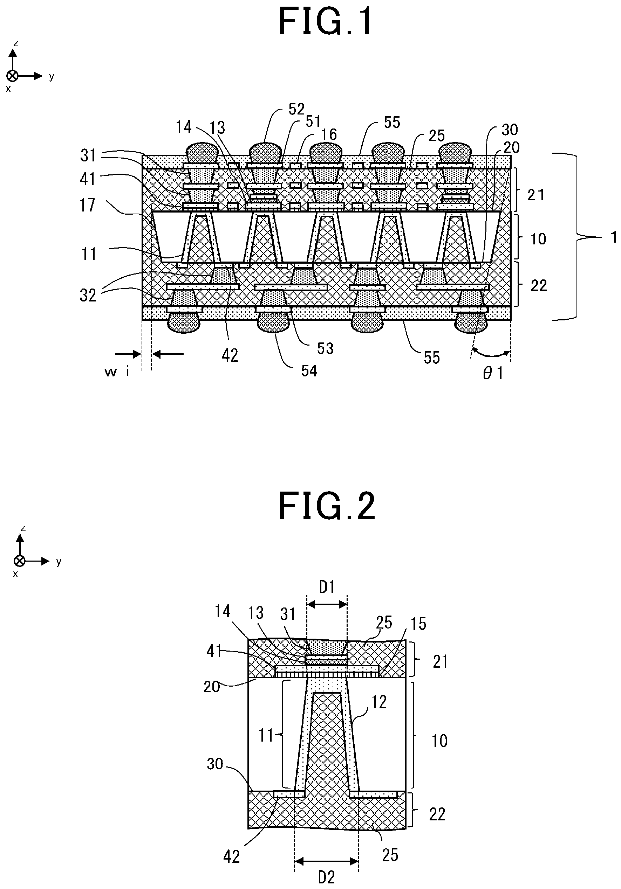

A multilayer wiring substrate according to a first embodiment will be described with reference to Figs. 1 and 2. Fig. 1 is a cross-sectional view showing a multilayer wiring substrate according to the first embodiment of the present invention. Fig. 2 is a cross-sectional view showing the structure of a through electrode within the multilayer wiring substrate according to the first embodiment. As shown here, the multilayer wiring substrate 1 includes a core substrate 10 (hereinafter, also referred to as "glass core substrate 10"), which is a glass substrate. The core substrate 10 has a first wiring layer 21 formed on an upper surface in the positive Z-axis direction (hereinafter, also referred to as "first surface 20"), and a second wiring layer 22 formed on a lower surface in the negative Z-axis direction (hereinafter, also referred to as "second surface 30").

The core substrate 10 has the first surface 20, and the second surface 30 opposing the first surface 20. The core substrate 10 is formed having through holes 11 that penetrate from the first surface 20 to the second surface 30, or in other words, penetrate the front and back surfaces. A seed metal layer is formed on an inner wall surface of the through holes 11, and as a result, through electrodes 12 are formed that electrically connect the first surface 20 side and the second surface 30 side of the core substrate 10. Furthermore, as shown in Fig. 2, a capacitor electrode 13 is disposed above the through electrode 12 in the first wiring layer 21. Note that the circuit elements other than a capacitor, such as an inductor, can be built into the first wiring layer 21.

The configuration of the first wiring layer 21, which is a wiring layer formed on the first surface 20 of the core substrate 10, will be described. Through electrode connection portions 41 (hereinafter, also referred to as "first conductive portions") are disposed inside the first wiring layer 21, which are electrodes connected to the through electrodes 12 via a hydrofluoric acid resistant metal layer 15, and conductive electrodes 31 are provided on the through electrode connection portion 41. A capacitor electrode 13, a dielectric layer 14, and a through electrode connection portion 41 (and a hydrofluoric acid resistant metal layer 15) form a metal-insulator-metal (MIM) structure. Furthermore, the wiring 16 represents the wiring disposed inside the first wiring layer 21, and connects the through electrodes 12, the conductive electrodes 31, and the like. The through electrode connection portions 41, the conductive electrodes 31, the capacitor electrodes 13, the dielectric layers 14, and the wiring 16 are each protected by an insulating resin layer 25. In addition, if the multilayer wiring substrate 1 is used as a relay substrate that connects a plurality of semiconductor elements, that is, as an interposer substrate, semiconductor element bonding pads 51 represent bumps that are used when mounting other semiconductor elements or when connecting to other semiconductor elements. The solder resist 55 is a film composed of an insulating member for protecting the multilayer wiring substrate 1. Here, two conductive electrodes 31 are provided stacked inside the first wiring layer 21. This indicates that the first wiring layer 21 is prepared by stacking two wiring layers.

Note that, with respect to the formation method of a capacitor having the capacitor electrode 13, a portion of a wiring layer (the first wiring layer or the second wiring layer) is a lower electrode, a dielectric layer is laminated on the wiring layer so as to cover part or all of the upper surface of the lower electrode, and a capacitor is formed by disposing an upper electrode on the dielectric layer so as to cover part or all of the dielectric layer in a plan view, cover part or all of the lower electrode, and not be electrically connected to the lower electrode. Moreover, the dielectric layer and the upper electrode are disposed within a thickness direction range of an insulating layer disposed between the conductive layer containing the lower electrode and the conductive layer formed directly thereabove. Also, an inductor is formed by connecting a portion of the wiring of the wiring layer, or by connecting a portion of the wiring of the wiring layer and the through electrode.

The configuration of the second wiring layer 22, which is a wiring layer formed on the second surface 30 of the core substrate 10, will be described. Through electrode connection portions 42 (hereinafter, also referred to as "second conductive portions") are disposed inside the second wiring layer 22, and are electrodes that are connected to the through electrodes 12 that are formed to match the shape of the opening end of the through electrodes 12. The conductive electrodes 32 are connected to the through electrode connection portions 42. A predetermined combination of the through electrode connection portions 42 disposed in the second wiring layer 22 and the through electrode connection portions 41 disposed in the first wiring layer 21 are electrically connected via the through electrodes 12. The substrate bonding solder 54 represent bumps that are used when connecting to a printed wiring substrate. The solder resist 55 is a film composed of an insulating member for protecting the multilayer wiring substrate 1. Here, the conductive electrodes 32 form conductive paths inside the second wiring layer 22 by being stacked or via another wiring layer. This indicates that the second wiring layer 22 is prepared by stacking two wiring layers.

The first wiring layer 21 and the second wiring layer 22 include the insulating resin layer 25, and the side surface of the core substrate 10 is covered with the same type of insulating resin as that constituting the insulating resin layer 25.

Note that, in the description below, although an example will be illustrated in which the multilayer wiring substrate 1 includes the first wiring layer 21 and the second wiring layer 22, the present invention is not limited to a case that includes the first wiring layer 21 and the second wiring layer 22. A laminate that is a layer having a laminated structure other than the first wiring layer 21 and the second wiring layer 22 may be formed, and in this case the multilayer wiring substrate 1 may also be referred to as a glass core laminate structure. Furthermore, when a wiring substrate is formed in the glass core laminate structure, the glass core laminate structure can be referred to as a glass core wiring substrate. In addition, depending on the number of wiring layers, the structure may be referred to as a glass core multilayer wiring substrate. Here, the glass core laminate structure includes the glass core substrate 10 having the first surface 20, and the second surface 30 opposing the first surface, and a laminate including, above the first surface 20 and below the second surface 30, a layer formed of a material different from that of the glass core substrate 10. The side surface of the glass core laminate structure is covered with the same material as one material forming the laminate.

Furthermore, the glass core substrate 10 has the plurality of through holes 11 that penetrate from the first surface 20 to the second surface 30, at least some of the through holes 11 are through electrodes 12 formed by laminating a conductive layer on the inner wall thereof, the glass core substrate 10 includes the first wiring layer 21 containing a conductor on the first surface 20, the second wiring layer 22 containing a conductor on the second surface 30, and the first wiring layer 21 and the second wiring layer 22 are electrically connected by the through electrodes 12.

In addition, a first insulating resin layer is laminated and disposed on the first wiring layer 21, a second insulating resin layer is laminated and disposed on the second wiring layer 22, the inside of the through electrodes 12 is filled by the insulating resin extending from the first insulating resin layer or the second insulating resin layer, and the side surface of the glass core substrate 10 is covered with the insulating resin extending from the first insulating resin layer or the second insulating resin layer.

Also, a wiring layer and an insulating layer are further alternately laminated one or more times on the first insulating resin layer, a wiring layer and an insulating layer are further alternately laminated one or more times on the second insulating resin layer, and as a result of through electrodes provided inside the insulating layer, the wiring layers above and below are electrically connected.

### (Dimensions and Composition of Multilayer Wiring Substrate)

The relationship between an opening diameter D1 on the first surface 20 side and an opening diameter D2 on the second surface 30 side of the through electrode 12 (first surface side opening diameter D1 / second surface side opening diameter D2) is in a range of 0.35 or more and 0.65 or less. As a result of making the opening diameter on the first surface 20 side smaller than the opening diameter on the second surface 30 side, the capacitor electrode 13 can be stably formed on the through electrode 12.

The thickness of the core substrate 10 is in a range of 50 µm or more and 150 µm or less, and the thickness can be set according to the characteristic values of the capacitor electrode 13, inductors, resistors, and the like, formed in the first wiring layer 21. When the thickness of the core substrate 10 is 200 µm or more, the relationship between the opening diameter D1 on the first surface 20 side and the opening diameter D2 on the second surface 30 side (first surface side opening diameter D1 / second surface side opening diameter D2) becomes 0.35 or more and 0.65 or less, and it becomes difficult to ensure the formation of the capacitor electrode 13 on the through electrode 12, and the connection reliability of the through electrode 12. The thickness of the core substrate 10 is more preferably in a range of 100 µm or more and 150 µm or less.

Note that the relationship between the opening diameter D1 on the first surface 20 side and the opening diameter D2 on the second surface 30 side may be set as appropriate as long as the relationship is in the above range.

The insulating resin layer 25 has a relative dielectric constant in a range of 3.1 or more and 3.5 or less, and a dielectric loss tangent in a range of 0.002 or more and 0.012 or less. The insulating resin layer 25 is formed of a thermosetting resin.

As the thermosetting resin, an epoxy resin, a polyimide resin, a polyamide resin, or a composite material of these, which is filled with 65% or more and 80% or less of a filler material that at least contains SiO₂ as a component, is used. If the fill rate of the SiO₂ filler material is 65% or less, the relative dielectric constant and dielectric loss tangent fall outside the above ranges, which causes a reduction in the transmission characteristics. The fill rate of the SiO₂ filler material is preferably 72% or more.

In addition, among the composite materials mentioned above, materials that are highly filled by the SiO₂ filler material have a low linear expansion coefficient of the insulating resin which is close to the linear expansion coefficient of glass materials. Therefore, by using such a material, it is possible to reduce the stress that may be generated when the wiring layers are formed on the core substrate 10. In this way, the values of the relative dielectric constant and the dielectric loss tangent can be kept within the above ranges, and the transmission characteristics can be prevented from being adversely affected.

On the side surface of the multilayer wiring substrate 1, the insulating resin layer 25 included in the first wiring layer 21 and the second wiring layer 22 and the insulating resin formed on the side surface of the core substrate 10 are exposed. A thickness wi of the insulating resin on the side section of the multilayer wiring substrate 1 is at least 50 µm or more when measured in the horizontal direction (the direction in which the multilayer wiring substrate 1 spreads). Assuming a vertical straight line from the first surface 20 to the second surface 30, and an angle θ1 formed between the straight line and the side surface, the side surface of the core substrate 10 reaches the second wiring layer 22 inclined such that θ1 is in a range of 21° or more and 35° or less with respect to the edge portion of the core substrate 10 of the first wiring layer 21. Moreover, the shape of the side surface of the multilayer wiring substrate 1 is a shape that extends in the same vertical direction as the direction of the vertical straight line.

The side surface of the multilayer wiring substrate 1, which includes the side surface of the core substrate 10, is covered with an insulating resin material, and as a result is protected by the insulating resin material. As a result, stress generated in the first wiring layer 21 or the second wiring layer 22 formed on the upper and lower surfaces of the core substrate 10 can be dispersed to the other wiring layer through the insulating resin on the side surface of the core substrate 10, and further, µ-cracks and chipping of the edge portions of the core substrate 10 can be suppressed, which enables the reliability of the multilayer wiring substrate 1 to be enhanced.

The capacitors formed in the first wiring layer 21 of the multilayer wiring substrate 1 have an MIM structure. From the viewpoint of the insulation properties and the relative dielectric constant, the material of the dielectric layer 14 forming the capacitors can be at least one material selected from alumina, silica, silicon nitride, tantalum oxide, titanium oxide, calcium titanate, barium titanate, and strontium titanate. Furthermore, as the material used to form the upper and lower electrodes of the MIM structure, for example, at least one of Cu, Ni, Al, Ti, Cr, Mo, W, Ta, Au, Ir, Ru, Pd, Pt, AlSi, AlSiCu, AlCu, NiFe, and Cu alloy may be applied. For example, Cu is a preferable material.

The core substrate 10 used in the multilayer wiring substrate 1 is a transparent glass material having light transmittance. The components of the glass, the mixing ratio of each component contained in the glass, and the production method of the glass are not particularly limited. Examples of the glass include non-alkali glass, alkali glass, borosilicate glass, quartz glass, sapphire glass, and photosensitive glass, but any glass material containing silicate as a main component may be used. Further, other glass materials may also be used. However, in the multilayer wiring substrate according to the present embodiment, it is preferable that non-alkali glass is used.

In the core substrate 10, glass produced by a float process, a down-draw process, a fusion process, an up-draw process, a roll-out process, or the like, is used, but a glass material produced through any process may be used. The glass preferably has a linear expansion coefficient of in a range of -1 ppm/K or more and 15.0 ppm/K or less. This is because, when the linear expansion coefficient is less than -1 ppm/K, it is difficult to even select a glass material. On the other hand, when the linear expansion coefficient exceeds 15.0 ppm/K, the difference in the thermal expansion coefficient with that of other layers becomes large, and the reliability decreases when used in the multilayer wiring substrate. Furthermore, when a silicon chip is mounted on the multilayer wiring substrate 1 of the present embodiment, the connection reliability with the silicon chip decreases. Note that the linear expansion coefficient of the glass is more preferably in a range of 0.5 ppm/K or more and 8.0 ppm/K or less, and even more preferably in a range of 1.0 ppm/K or more and 4.0 ppm/K or less.

### <First Production Method According to Embodiment of Present Invention>

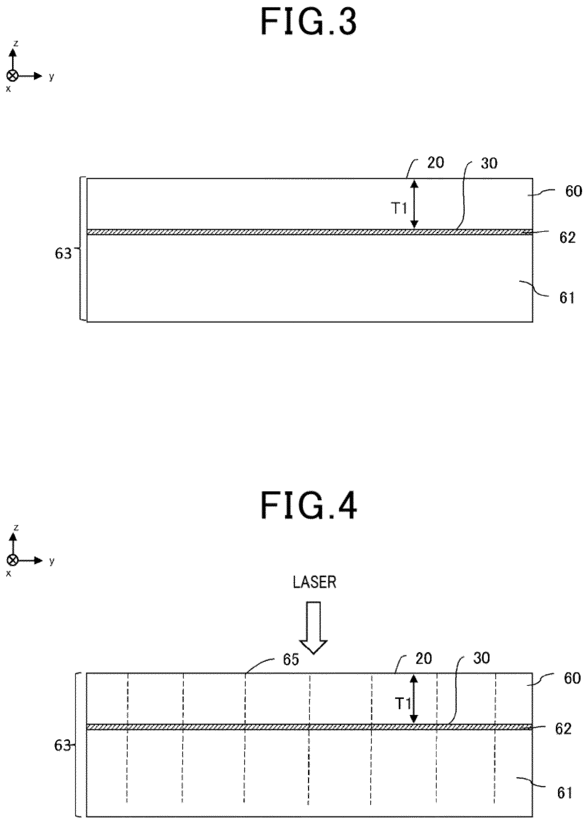

A production method for the multilayer wiring substrate 1 of the first embodiment will be described below with reference to Figs. 3 to 15.

### (Adhesion of First Support Body)

First, a step of adhering a first support body 61 to a glass substrate 60, which is the base material substrate, will be described with reference to Fig. 3. Fig. 3 is a cross-sectional view illustrating an adhesion step of the first support body 61 in the production method according to the first embodiment.

The glass substrate 60 has the first surface 20 and the second surface 30. As shown here, the first support body 61 is bonded to the glass substrate 60 using a first adhesive layer 62 to form a laminate structure 63 consisting of the glass substrate 60, the first adhesive body 62, and the first support body 61.

Note that, in the drawings, although the first adhesive layer has a negligible thickness compared to the thickness of the glass substrate 60 and the first support body 61, and can also be described as an interface between the glass substrate 60 and the first support body 61, it is illustrated in the form of a layer having a thickness for ease of illustration. Furthermore, although the glass substrate 60 spreads in the Y-axis direction, only a portion is shown in the drawings, and therefore, the edge portions in the Y-axis direction are illustrated as straight lines.

The first adhesive layer 62 is an adhesive layer for temporarily fixing the first support body 61 to the glass substrate 60. The first adhesive layer 62 is a surface containing hydroxyl groups that is formed on the second surface 30 of the glass substrate 60. The configuration of the adhesive interface may contain a plurality of other functional groups as long as hydroxyl groups are included. For this reason, the material of the first adhesive layer 62 can be appropriately selected from among resins that absorb light, such as UV light, and then become detachable by generating heat, sublimating, or undergoing degradation, resins or functional groups that become detachable by foaming due to heat, and the like.

In order to bond the first support body 61 to the glass substrate 60, for example, a laminator, a vacuum pressure press, a reduced pressure bonding machine, and the like, can be used.

In this way, by forming an interface containing hydroxyl groups on the second surface 30 of the glass substrate 60, it is possible to form hydrogen bonds using the hydroxyl groups between the glass substrate 60 and the first support body 61. Note that the adhesive layer containing hydroxyl groups can also be formed on the first surface 20 of the glass substrate 60.

The first support body 61 is preferably formed of the same material as the glass substrate 60. When the material of the glass substrate 60 is non-alkali glass, it is preferable that the material of the first support body 61 is also non-alkali glass. Furthermore, the thickness of the first support body 61 can be set as appropriate according to a thickness T1 of the glass substrate 60. However, it is preferable that the thickness enables transport during the production process, for example, and the thickness T1 of the glass substrate 60 is in a range of 75 µm or more and 200 µm or less, and it is possible to set the thickness of the first support body 61 to a range of 300 µm or more and 1,500 µm or less.

Note that, in the present embodiment, the first support body 61 is formed of a glass material, and the hydroxyl groups and a plurality of functional groups are used as an adhesive interface.

The adhesion strength between the glass substrate 60 and the first support body 61 is preferably in a range of 0.15 J/cm² or more and 0.45 J/cm² or less. When a strength in the above range cannot be obtained, the adhesion strength may be improved by performing annealing treatment after forming the hydroxyl groups. When the adhesion strength is 0.15 J/cm² or less, there is a high likelihood that detachment will occur at the interface between the glass substrate 60 and the first support body 61 during the process flow. Conversely, when the adhesion strength is 0.45 J/cm² or more, the adhesion strength is more likely to give rise to problems in the detachment step described separately. The adhesion strength is more preferably in a range of 0.25 J/cm² or more and 0.4 J/cm² or less. Note that the adhesion strength is measured using a crack opening method, but the measurement method is not limited to this.

### (Formation of Laser Modified Portions)

Next, a formation step of the laser modified portions will be described with reference to Fig. 4. Fig. 4 is a cross-sectional view illustrating the formation step of the laser modified portions in the production method according to the first embodiment. In Fig. 4, the broken lines represent the laser modified portions 65. As shown in Fig. 4, a laser is irradiated to the laminate structure 63 from the first surface 20 side to form the laser modified portions 65. The laser modified portions 65 extend, for example, in a vertical direction with respect to the glass substrate 60, and can be formed in desired positions over substantially the entire surface of the glass substrate 60. At this time, the laser modified portions 65 may be formed so as to reach the first adhesive layer 62 and the first support body 61.

In the present embodiment, the processing conditions (process window) of the laser irradiation can be widened by irradiating the laser in a state where the first support body 61 is stacked on the glass substrate 60, and it also becomes possible to form the laser modified portions 65 in desired positions with respect to the glass substrate 60.

Here, when an adhesive layer composed of a resin is used as the first adhesive layer 62, cracks may be generated in the resin of the adhesive agent due to laser irradiation, which may cause a phenomenon in which the adhesive resin remains on the glass substrate 60 when the first support body 61 is detached from the glass substrate 60. If such an adhesive resin remains on the glass substrate 60, it may result in problems in the subsequent through hole formation step performed by hydrofluoric acid etching. For example, there is a concern that surface recesses and protrusions may be formed on the glass substrate 60. For this reason, it is preferable to use a surface containing hydroxyl groups to adhere the glass substrate 60 and the first support body 61 together, rather than using a resin adhesive layer.

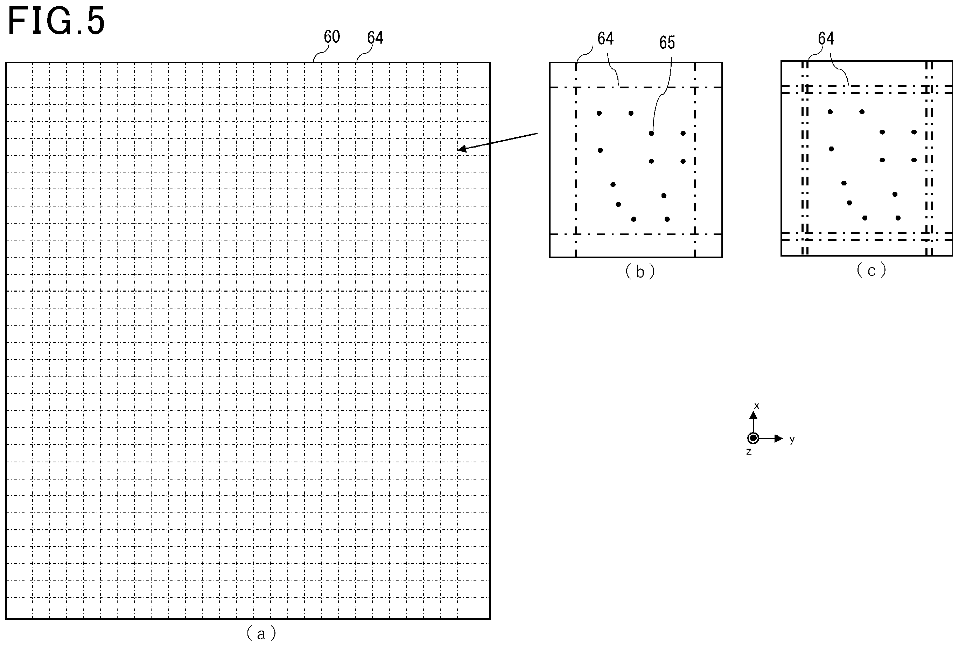

Furthermore, Fig. 5 is a diagram illustrating locations in which laser modified portions are formed in the production method according to the first embodiment. Fig. 5(a) is a plan view when the glass substrate 60 is viewed from the positive Z-axis direction, and Fig. 5(b) is an example showing enlarged a portion of the glass substrate 60. Here, the dashed dotted lines represent singulation lines 64. The singulation lines represent positions in which separation grooves are formed when the multilayer wiring substrate is separated from the glass substrate 60. In addition, the laser modified portions 65, which are the starting points of the through holes 11, are indicated by black circles. The laser modified portions 65 are locations where the through holes 11 or the separation grooves are formed.

Furthermore, Fig. 5(c) is another example showing enlarged a portion of the glass substrate in a separate example. As shown here, when the laser modified portions of the separation grooves are formed, it is also possible to form a plurality of laser modified portions by offsetting the irradiation positions of the laser to form the singulation lines 64.

### (Formation of First Wiring Layer)

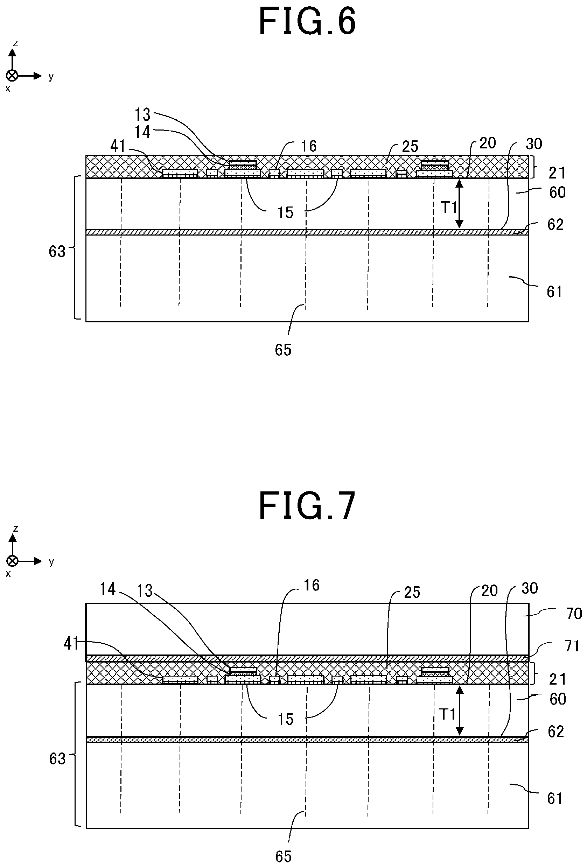

Next, a formation step of the first wiring layer 21 will be described with reference to Fig. 6. Fig. 6 is a cross-sectional view illustrating a formation step of the first wiring layer in the production method according to the first embodiment. As shown here, the first wiring layer 21 including a conductive layer and an insulating layer are formed on the first surface 20 on the glass substrate 60 of the laminate structure 63.

First, a seed layer containing a hydrofluoric acid resistant metal layer 15 is formed on the glass substrate 60. The hydrofluoric acid resistant metal layer 15 on the glass substrate 60 is an alloy layer containing at least one of chromium and nickel, and is formed by a sputtering process in a range of 10 nm or more and 1,000 nm or less.

Then, a conductive metal film is formed having a desired thickness on the hydrofluoric acid resistant metal layer 15. The material of the conductive metal film can be appropriately selected from, for example, Cu, Ni, Al, Ti, Cr, Mo, W, Ta, Au, Ir, Ru, Pd, Pt, AlSi, AlSiCu, AlCu, NiFe, ITO, IZO, AZO, ZnO, PZT, TiN, and Cu₃N₄.

The electrode connection portions (electrodes) and the wiring are formed by, for example, a semi-additive process (SAP). In a semi-additive process, a photoresist is used to form a desired pattern. Generally, a dry film resist is used, but a liquid resist may also be used. The resist is exposed to light and developed to form the desired pattern, and then a plating film having a thickness of 2 µm or more and 20 µm or less is formed by electrolytic plating. The resist pattern that is no longer needed is stripped, and the seed layer is etched to form the wiring 16 positioned between the laser modified portions 65 and the through electrode connection portions 41, which are positioned above the laser modified portions.

From the viewpoint of the insulation properties and the relative dielectric constant, the formation of the dielectric layer 14 on the through electrode connection portion 41 can be performed using at least one material selected from alumina, silica, silicon nitride, tantalum oxide, titanium oxide, calcium titanate, barium titanate, and strontium titanate. The thickness of the dielectric layer 14 is preferably in a range of 10 nm or more and 5 µm or less. When the dielectric layer 14 has the thickness of less than 10 nm, the insulation properties cannot be maintained, and the function as a capacitor cannot be exhibited. When the thickness of the dielectric layer 14 exceeds 5 µm, not only will too much time be taken to form the film, making it unsuitable for mass production, the step of removing unnecessary parts will take even more time. The thickness of the dielectric layer 14 is preferably in a range of 50 nm or more and 1 µm or less.

When the capacitor electrode 13 is formed, a lower electrode layer and an upper layer electrode are formed separately. From the viewpoint of adhesion and electrical conductivity, the lower electrode layer is formed using at least one material from among Cu, Ni, Al, Cr, Mo, W, Ta, Au, Ir, Ru, Pd, Pt, AlSi, AlSiCu, AlCu, NiFe, and Cu. For example, Ti is superior from the viewpoint of adhesion, electrical conductivity, ease of production, and cost.

A seed metal layer is formed on the upper electrode of the capacitor electrode 13, and an electrolytic plating layer is further formed thereon. As the seed metal layer, for example, it is possible to apply at least one of Cu, Ni, Al, Ti, Cr, Mo, W, Ta, Au, Ir, Ru, Pd, Pt, AlSi, AlSiCu, AlCu, NiFe, and Cu. From the viewpoint of ease of subsequent etching removal, it is preferable to use copper. It is preferable that the thickness of the seed metal layer is in a range of 10 nm or more and 5 µm or less. When the seed metal layer has a thickness of less than 10 nm, energization failure may occur during the subsequent electroplating step. When the thickness of the seed metal layer exceeds 5 µm, the time taken for etching removal becomes long. The thickness of the seed metal layer is more preferably in a range of 100 nm or more and 500 nm or less.

Then, an electrolytic plating layer is formed as the upper electrode of the capacitor electrode 13. Copper electroplating is simple and inexpensive, and has good electrical conductivity. In addition to copper electroplating, nickel electroplating, chromium electroplating, palladium electroplating, gold electroplating, rhodium electroplating, iridium electroplating, or the like, may be used. The seed metal layer is removed after forming the upper electrode. It is possible to appropriately select wet etching, dry etching, or the like, according to the application.

In terms of the formation of the capacitor electrode 13, in a conventional production method for producing a multilayer wiring substrate using a substrate in which through holes 11 are formed in advance, because it is not possible to deposit a conductive material on the through holes, it is necessary to form the MIM structure while avoiding the through holes. On the other hand, according to the production method according to the present embodiment, because the formation step of the wiring and the formation step of the capacitor electrodes are performed before the formation step of the through holes, the capacitor electrodes 13 can be formed near the through holes and above the through holes, or in other words, can be formed without being restricted by the positions of the through holes. For example, the capacitor electrodes 13 can be provided directly above the through holes. This makes it possible to shorten the transmission distance to the capacitors, and to avoid a reduction in the transmission characteristics. In addition, by forming the lower electrode layer when forming the capacitor electrode 13, variations in the capacitance of the capacitor can be reduced.

Finally, the insulating resin layer 25 is formed. The insulating resin layer 25 is formed of a thermosetting resin, and the material preferably includes at least one of an epoxy resin, a polyimide resin, and a polyamide resin, includes a SiO₂ filler material, and is a material in the form of a liquid or film. In the case of a resin in the form of a liquid, the insulating layer can be formed by spin coating, and in the case of a resin in the form of a film, a vacuum laminator is used to apply heat and pressure under vacuum to form the insulating layer. The material of the insulating resin layer 25 can be appropriately selected as required. However, when a photosensitive insulating resin material is used, because it becomes difficult to fill the SiO₂ filler material in order to ensure the photolithography properties, the material is limited to a non-photosensitive thermosetting resin.

### (Adhesion of Second Support Body)

Next, an adhesion step of a second support body will be described with reference to Fig. 7. Fig. 7 is a cross-sectional view illustrating the adhesion step of the second support body in the production method according to the first embodiment. As shown here, a second adhesive layer 71 is formed on the first wiring layer 21 of the laminate structure 63, and the second support body 70 is adhered to the second adhesive layer 71.

The second adhesive layer 71 can be selected as appropriate from among resins that, like the first adhesive layer 62, absorb light such as UV light, and then become detachable by generating heat, sublimating, or undergoing degradation, resins that become detachable by foaming due to heat, functional groups that temporarily fix the glass substrate 60 and the first support body 61, and the like, but is preferably formed of a different material to the first adhesive layer 62.

The second support body 70 is preferably the same material as the glass substrate 60. When the glass substrate 60 is non-alkali glass, it is preferable that the second support body 70 is also non-alkali glass. Furthermore, the thickness of the second support body can be set as appropriate according to the thickness of the glass substrate 60. However, the thickness is preferably a thickness that allows transportation, and is in a range of 300 µm or more and 1,500 µm or less.

### (Detachment of First Support Body)

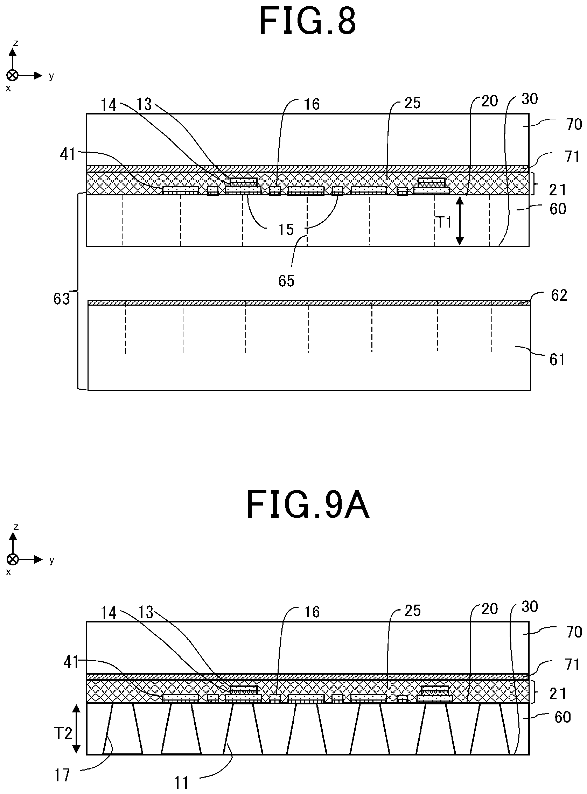

Next, a detachment step of the first support body will be described with reference to Fig. 8. Fig. 8 is a cross-sectional view illustrating the detachment step of the first support body 61 in the production method according to the first embodiment. As shown here, the interface between the glass substrate 60 and the first adhesive layer 62 is detached, and the first adhesive layer 62 and the first support body 61 are separated from the glass substrate 60.

When separating the first support body 61 from the glass substrate 60, it is possible to form a detachment starting portion by applying a physical force to the side surface of the first adhesive layer 62, and then detach the surface of the first adhesive layer 62 by applying a force starting at the detachment starting portion.

More specifically, the glass substrate 60 and the first support body 61 can be separated by using, as the detachment starting portion, a location on the side surface of the first adhesive layer 62 in which a scratching process has been performed with a cutter or the like, and then applying a force in a direction that pulls the first support body 61 and the glass substrate apart.

Note that, when the scratching process is performed in a state where a force is applied that pulls the first support body 61 and the glass substrate apart, the detachment process can be performed smoothly. Depending on the material used for the first adhesive layer 62, a detachment method that is suitable for the material used is appropriately selected from UV light irradiation, heat treatment, physical detachment, and the like. Furthermore, if any residue of the first adhesive layer 62 remains on the glass substrate 60, plasma washing, ultrasonic washing, water washing, solvent washing using alcohol, or the like, may be performed.

### (Formation of Through Holes by Etching)

Next, a formation step of the through holes by etching will be described with reference to Figs. 9A to 9F. Fig. 9A is a cross-sectional view illustrating the formation step of the through holes by etching in the production method according to the first embodiment. The shape of the glass substrate 60 after hydrofluoric acid etching is shown in Fig. 9A. As a result of hydrofluoric acid etching, the through holes 11 and separation grooves 17 described later are formed at the same time, and the separation grooves 17 have a structure in which the insulating resin layer 25 is exposed. As shown here, the laser modified portions 65 are selectively removed from the second surface 30 side of the glass substrate 60 by etching. As a result, the through holes 11 are formed. In terms of the etching, wet etching using an aqueous solution of hydrogen fluoride is suitable. The etching amount using the aqueous hydrogen fluoride solution is appropriately set according to the thickness of the glass multilayer wiring substrate. For example, if the thickness T1 of the glass substrate 60 is 200 µm, the etching amount is preferably in a range of 50 µm or more and 175 µm or less. Note that, although a structure in which the insulating resin layer 25 is exposed is shown here, the structure is not limited to this. When the seed layer containing the hydrofluoric acid resistant metal layer 15 of the first wiring layer 21 is left in the separation grooves 17, the seed layer of the first wiring layer 21 remains in the singulation line portions.

Note that, when the laser modified portions 65 are etched, the glass substrate 60 is also etched in the same manner. A thickness T2 of the glass substrate 60 after etching is preferably in a range of 25 µm or more and 150 µm or less. Here, in the conventional multilayer wiring substrate, the thickness of the core substrate is generally 300 µm or more and 400 µm or less. Because a thin core substrate can be achieved in the first embodiment, the effect on the transmission characteristics can be suppressed.

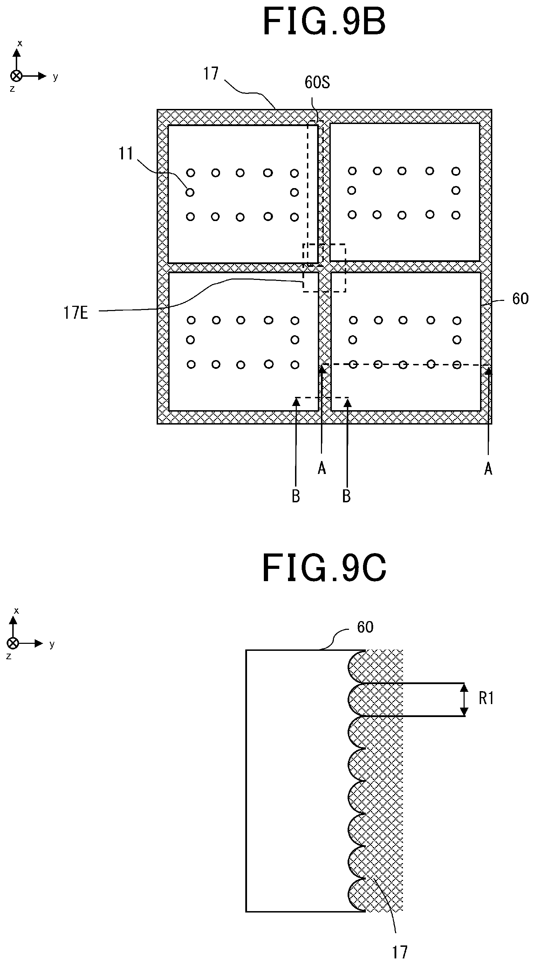

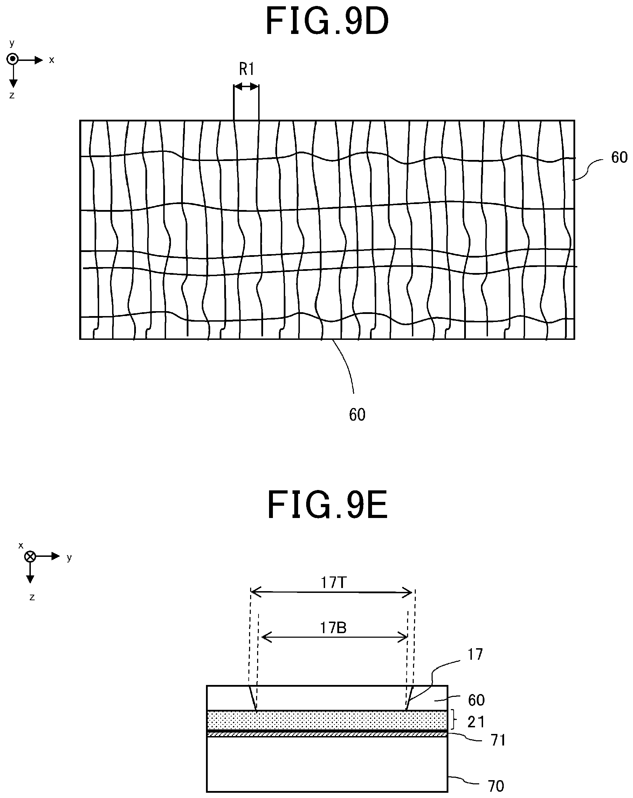

Next, Fig. 9B is a bottom view showing a case where separation grooves 17 have been formed. Fig. 9C is a diagram schematically showing enlarged a portion of the bottom view of a separation groove. Fig. 9C is a diagram showing the region 60S of Fig. 9B. Fig. 9D is a diagram schematically showing a side surface of the separation groove. Fig. 9D is a diagram schematically showing a case where the region 60S in Fig. 9B is viewed from a side surface. Fig. 9D can be acquired, for example, by SEM (scanning electron microscope). In the separation groove 17 in Fig. 9C, vertical ridge lines are formed in the side surface of the glass substrate 60 according to the processing pitch of the laser modified portions for forming the separation groove 17, which are visually recognized as connected protruding portions in the normal direction (Z-axis direction) of the glass substrate. Moreover, the solid lines shown in Fig. 9D represent ridge lines of recesses and protrusions formed on the side surface of the glass substrate 60, which are made up of vertical ridge lines, and horizontal ridge lines which are substantially perpendicular to the vertical ridge lines. As a result, a large number of substantially rectangular recessed portions are formed on the side surface of the glass substrate 60. In terms of the dimensions of the rectangles, for example, when the laser modified portions are processed with a pitch of 10 µm, a spacing R1 of the ridge lines formed on the lower surface of the separation groove 17 shown in Fig. 9C, or a spacing R1 of the ridge lines formed on the side surface shown in Fig. 9D, is 10 µm or less. It is possible to arbitrarily set the processing pitch of the laser modified portions according to the spacing R1 between the ridge lines. In addition, on the upper surface of the separation groove 17 in Fig. 9C, the width of the recesses and protrusions formed along the ridge lines is also referred as to as a "PV of the ridge lines" (peak to valley) below. The PV value is approximately 10 µm or less. Moreover, when the range is specified in more detail, for example, the PV value of the vertical ridge lines and horizontal ridge lines can be set to 1.8 µm or more and 10.6 µm or less.

The side surface of the core substrate has the plurality of substantially rectangular recessed portions formed of the plurality of vertical ridge lines and horizontal ridge lines, and as an example, the dimension of the rectangles in the horizontal direction (in other words, the spacing between the vertical ridge lines) is 5 µm or more and 20 µm or less, the dimension in the vertical direction (in other words, the spacing between the horizontal ridge lines) is 2 µm or more and 25 µm or less, and the depth of the plurality of recessed portions is 0.5 µm or more and 11 µm or less.

The recesses and protrusions that appear on the surfaces of the glass substrate 60 in which the separation grooves 17 are formed are fine, and have the effect of improving the adhesion between the insulating resin layer 25 of the second wiring layer 22 described later, and the glass substrate 60. Note that Fig. 9A is a cross-sectional view taken along AA in Fig. 9B.

Furthermore, Fig. 9E is a diagram schematically showing enlarged the separation groove. Fig. 9E is a cross-sectional view taken along BB in Fig. 9B. In the separation groove 17, as shown in Fig. 9E, the relationship between a bottom portion processing width 17B and an opening portion opening width 17T (bottom portion processing width 17B / opening width 17T) can be formed in a range of 0.85 or more and 1.0 or less by changing the pitch interval and the number of laser modified portions. As a result of performing the processing with the range of the bottom portion processing width 17B of the separation groove 17 being the desired width, it is possible to adjust the amount of the insulating resin layer that is formed in the subsequent steps in the inclined section of the separation groove caused by the difference between the processing width 17B and the opening width 17T, and therefore, it becomes easier for the thickness of the insulating resin layer on the side surface of the glass substrate 60 after singulation of the multilayer wiring substrate to be formed with the desired thickness.

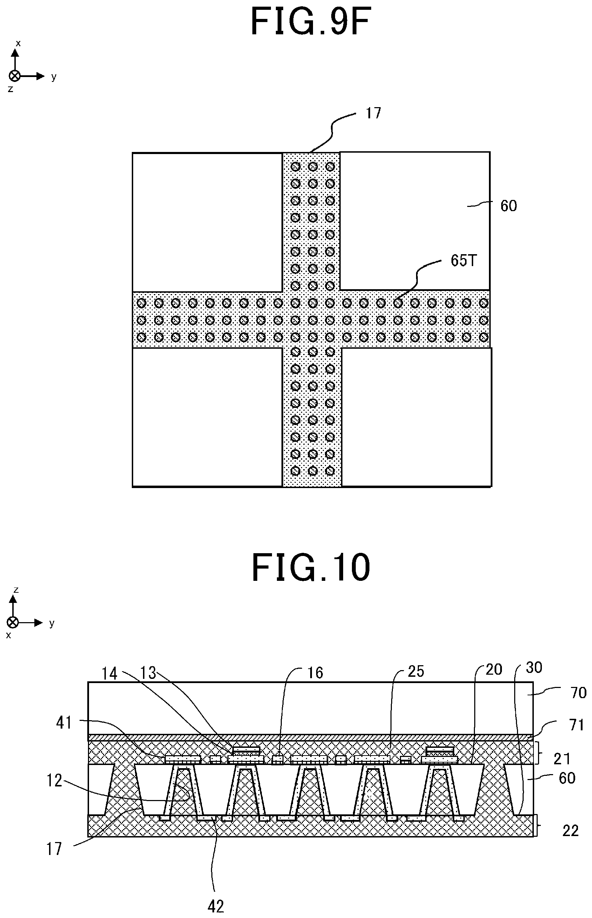

Fig. 9F is a diagram schematically showing enlarged a portion of the bottom view of the separation groove 17. Fig. 9F is a diagram showing the region 17E of Fig. 9B. At the bottom of the separation groove 17, after etching with hydrofluoric acid, transfer traces 65T of the laser modified portions are formed in the Cr, Cu and insulating resin layer at the bottom portion, forming fine recesses and protrusions. The recesses and protrusions produce an anchoring effect during the subsequent wiring formation and formation of the insulating resin of the second wiring layer, and enables the adhesion between the insulating resin layer 25 and the glass substrate 60 to be improved.

Note that, when the above description is applied to the glass core laminate structure, it is possible that at least a portion of the side surface of the glass core substrate 10 is formed having a plurality of substantially rectangular recessed portions in which a plurality of vertical ridge lines and horizontal ridge lines can be visually recognized.

### (Formation of Second Wiring Layer)

Next, a formation step of the second wiring layer will be described with reference to Fig. 10. Fig. 10 is a cross-sectional view illustrating the formation step of a second wiring layer in the production method according to the first embodiment. As shown here, the second wiring layer 22, which consists of the through electrode connection portions 42 and the insulating resin layer 25, is formed on the second surface 30 of the glass substrate 60. In the formation of the through electrodes 12 and the through electrode connection portions 42, a seed layer for supplying power is formed, pattern formation is performed using a resist, and a plating process is carried out so as to form a plating having a thickness of 2 µm or more and 20 µm or less. Then, the through electrodes 12 and the through electrode connection portions 42 are formed by stripping the resist pattern that is no longer needed, and removing the seed layer. Finally, the insulating resin layer 25 is formed, thereby forming the second wiring layer 22. The insulating resin layer 25 also fills the inside of the through electrodes 12. Note that, in the example described here, it is assumed that the insulating resin layers 25 formed in the first wiring layer 21 and the second wiring layer 22 are formed of the same material, but it is not limited to this. The insulating resin layers may be formed using different materials.

Because the second wiring layer 22 is not subjected to an etching process by an aqueous hydrogen fluoride solution in a subsequent step, it is possible to use a material that is different to that of the hydrofluoric acid resistant metal layer 15. In this case, a metal layer consisting of a material that is different to that of the hydrofluoric acid resistant metal layer 15 is formed on the side surface of the through holes 11, thereby forming the through electrode connection portions 42. Examples of materials that are different from the hydrofluoric acid resistant metal layer 15 include Ti and Cu, and a metal layer formed of one or more layers consisting of at least one of these materials is formed on the side surface of the through holes 11 and the second surface 30 of the glass substrate 60. The materials, the number of layers, and the like are not limited to those disclosed in the embodiments, and can be appropriately set as necessary.

Note that the sections of the through holes 11 that do not become the through electrodes 12 form the separation grooves 17. The separation grooves 17 are also filled with the insulating resin layer 25. The through holes 11 filled with the insulating resin material can also be referred to as resin through holes. As shown in Fig. 10, the resin through holes include those in which a conductive layer (metal layer) is formed, and those in which a conductive layer is not formed.

### (Detachment of Second Support Body)

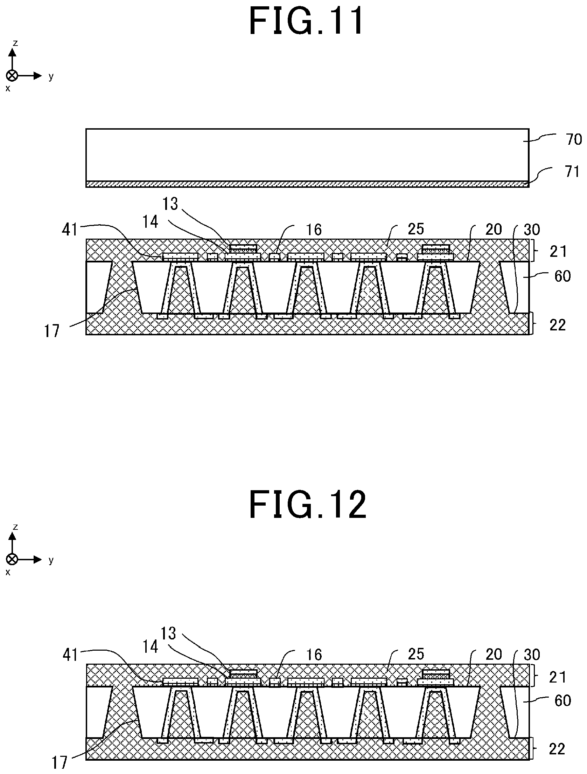

Next, a detachment step of the second support body 70 will be described with reference to Figs. 11 and 12. Fig. 11 is a diagram illustrating the detachment step of the second support body 70 in the production method according to the first embodiment. Furthermore, Fig. 12 is a diagram showing a state after the detachment step of the second support body 70 has been performed in the production method according to the embodiment of the present invention. As shown in Fig. 11, the interface between the first wiring layer 21 and the second support body 70 is detached, and the second support body 70 and the second adhesive layer 71 are separated. As a result, as shown in Fig. 12, the glass substrate 60 is obtained in which the first wiring layer 21 is formed on the first surface 20 side of the glass substrate 60, and the second wiring layer 22 is formed on the second surface 30 side.

When separating the second support body 70 from the first wiring layer 21, depending on the material used for the second adhesive layer 71, a detachment method that is suitable for the material used can be appropriately selected from UV light irradiation, heat treatment, physical detachment, and the like. Furthermore, if any residue of the second adhesive layer 71 remains on the bonding surface between the first wiring layer 21 and the second adhesive layer 71, plasma washing, ultrasonic washing, water washing, solvent washing using alcohol, or the like, may be performed.

### (Formation of Build-Up Layer)

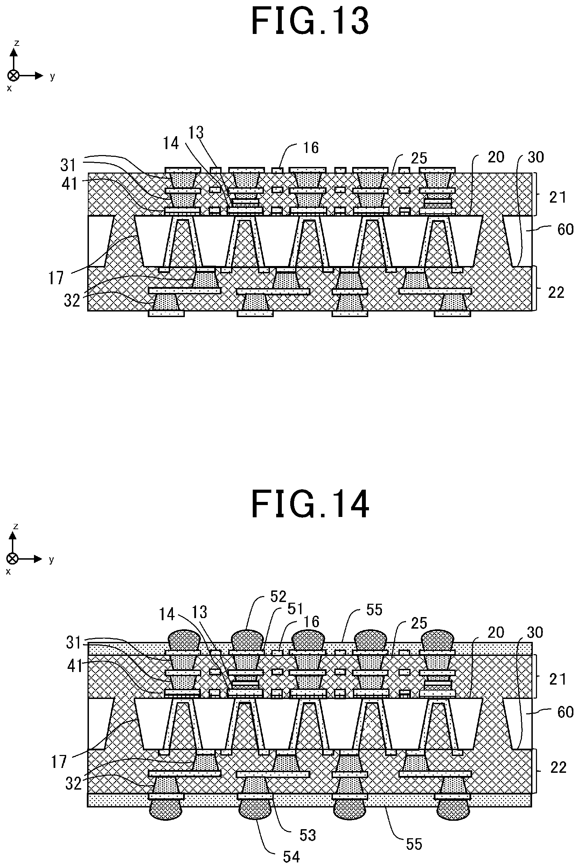

Next, a formation step of a build-up layer, or in other words, a layer in which the first wiring layer 21 and the second wiring layer 22 are laminated, will be described with reference to Fig. 13. Fig. 13 is a diagram illustrating the formation step of the build-up layer in the production method according to the first embodiment.

As shown in Fig. 13, the first wiring layer 21 on the first surface 20 side of the glass substrate 60 and the second wiring layer 22 on the second surface 30 side are formed having the conductive electrodes 31 on the first surface side for electrically connecting the first wiring layer, and the conductive electrodes 32 on the second surface side for electrically connecting the second wiring layer. The conductive electrodes 31 and 32 are formed by forming a via in the insulating resin layer 25 with a laser, forming a seed layer on the via, and then performing a semi-additive process (that is, a series of processes including resist pattern formation, a plating process, detachment of the resist, removal of the seed layer, and formation of the insulating resin layer).

Note that at least one or more layers are laminated in the first wiring layer 21 and the second wiring layer 22, and an appropriate number of layers can be set as required. In Fig. 13, two layers are laminated in both the first wiring layer 21 and the second wiring layer 22.

The laser used to form the conductive electrode 31 and the conductive electrode 32 may be different from the laser used to form the laser modified portions 65. For example, it is desirable to use a pulsed laser such as a carbon dioxide gas laser or a UV-YAG laser, and a laser with a µs-order pulse width is suitable.

### (Formation of Connection Pads)

Next, the formation of connection pads will be described with reference to Fig. 14. Fig. 14 is a diagram illustrating a formation step of connection pads in the production method according to the first embodiment. As shown here, after forming an outer protective film such as the solder resist 55 on the first wiring layer 21 and the second wiring layer 22, semiconductor element bonding pads 51 are formed on the first wiring layer 21, and substrate bonding pads 53 are formed on the second wiring layer 22. The semiconductor element bonding pads 51 and the substrate bonding pads 53 are subjected to surface treatment with Ni/Au, Ni/Pd/Au, IT, OSP (water-soluble preflux), and the like, and the semiconductor element bonding solder 52 and the substrate bonding solder 54 are formed as necessary to complete the multilayer wiring substrate. Note that Ni/Au indicates that both Ni and Au are used, and Ni/Pd/Au indicates that all of Ni, Pd, and Au are used.

### (Singulation)

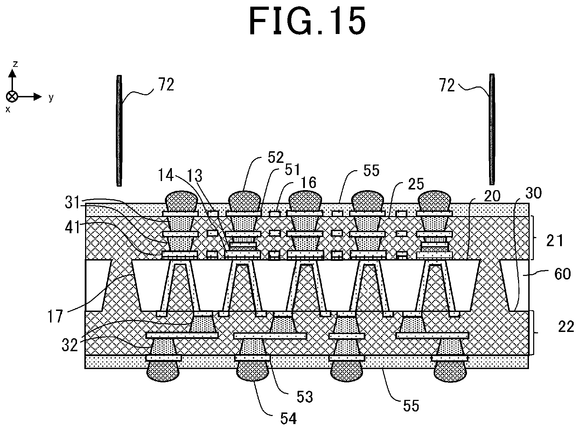

Next, singulation of the multilayer wiring substrate will be described with reference to Fig. 15. Fig. 15 is a cross-sectional view illustrating a singulation step in the production method according to the first embodiment. In terms of the singulation of the multilayer wiring substrate, as shown in Fig. 15, the singulation is performed along singulation lines formed in the hydrofluoric acid etching. Fig. 15 shows a case where blade dicing using a blade 72 is assumed, but a laser, scribing, or the like, may be used in addition to blade dicing. Furthermore, the singulation may be performed by combining blade dicing, a laser, and scribing.

### (Flowchart of Production Method According to First Embodiment)

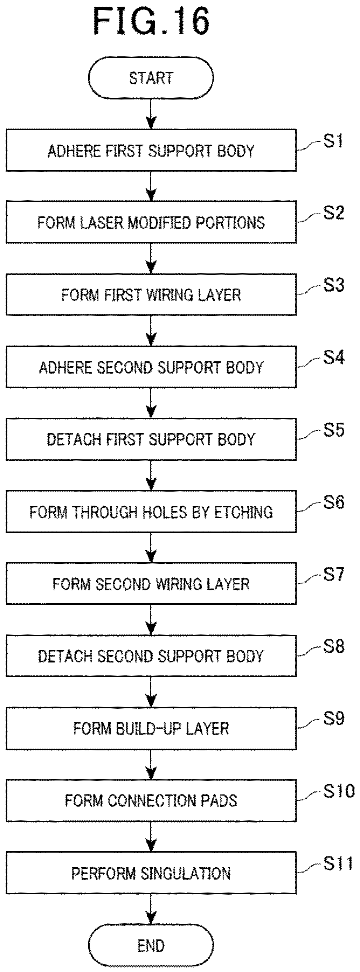

The steps described above are summarized in a flowchart. Fig. 16 is a diagram showing a flowchart of the production method according to the first embodiment.

Step S1 is an adhesion step of the first support body. The first support body is adhered to the base material substrate. In the first embodiment, the use of an adhesive layer containing hydroxyl groups has been illustrated.

Step S2 is a formation step of a laser modified portions. A laser is irradiated from the surface on the opposite side to the surface to which the first support body has been adhered. The laser modified portions represent the starting points of the through holes and the separation grooves.

Step S3 is a formation step of the first wiring layer. Electrodes, wiring, capacitors, inductors, and the like, can be formed in the first wiring layer.

Step S4 is an adhesion step of the second support body. The second support body is adhered to the first wiring layer.

Step S5 is a detachment step of the first support body. The base material substrate and the first support body are separated from the adhesive layer section.

Step S6 is a formation step of the through holes by etching. The sections from which the modified portions have been removed become the through holes 11 or the separation grooves 17.

Step S7 is a formation step of the second wiring layer. The through electrodes are formed in the through holes in the base material substrate, and electrodes that are electrically connected to the through electrodes and wiring are formed.

Step S8 is a detachment step of the second support body. The second support body is detached from the base material substrate.

Step S9 is a formation step of the build-up layer. Electrodes and wiring are formed in the first wiring layer and the second wiring layer.

Step S10 is a formation step of the connection pads. The connection pads are formed after forming a protective layer on the first wiring layer and the second wiring layer.

Step S11 is a singulation step. Dicing and the like of the base material substrate is performed to separate the multilayer wiring substrate.

Note that, when the above description is applied to the production method for a glass core laminate structure, the production method for a glass core laminate structure includes:
a first step of bonding a support body (first support body 61) to the second surface 30 of the glass core substrate 10 (step S1);
a second step of performing laser irradiation of separation groove forming regions (singulation lines 64) of the glass core substrate 10 from the first surface 20 side, and forming the laser modified portions 65 (step S2);
a third step of forming a laminate above the first surface 20 of the glass core substrate 10 (step S3);
a fourth step of detaching the support body from the glass core substrate 10 (step S5);
a fifth step of removing the laser modified portions by performing etching of the second surface 30 side of the glass core substrate 10, and forming the separation grooves 17 (step S6);
a sixth step of forming a laminate below the second surface 30 of the glass core substrate 10, and filling the separation grooves 17 (step S7); and
a seventh step of dicing the regions having the separation grooves 17 (step S11).

Furthermore, in the production method for a glass core laminate structure,
the material covering the side surface of the glass core laminate structure is an insulating resin material having insulating properties, and the layer containing the insulating resin material laminated in the third step is referred to as the first insulating resin layer, and the layer containing the insulating resin material laminated in the sixth step is referred to as the second insulating resin layer,
the second step is a step of forming the laser modified portions 65 by performing laser irradiation of the separation groove forming regions (singulation lines 64) and through hole forming regions of the glass core substrate 10 from the first surface 20 side,
the third step includes a step of forming the first conductive layer above the first surface 20 of the glass core substrate 10, and
the fifth step includes a step of simultaneously forming the separation grooves 17 and the through holes 11 by removing the laser modified portions 65 by performing etching from the second surface side 30 of the glass core substrate 10, and forming the second conductive layer above the second surface 30 of the glass core substrate 10 and on the inner surfaces of the through holes 11.

Moreover, in the production method for a glass core laminate structure,
the third step further includes
a step of forming the resin through holes in the first insulating layer,
forming the conductive layer above the first insulating layer and in the resin through hole, and
forming the insulating resin layer above the conductive layer, and
further includes repeating the series of steps of the formation of the resin through holes, formation of the conductive layer, and the formation of the insulating resin layer a predetermined number of times.In addition, in the production method for a glass core laminate structure,
in the third step, a capacitor is formed by forming the capacitor lower electrode in a portion of the first conductive layer, forming the dielectric layer so as to cover the upper surface or all of the capacitor lower electrode, and laminating the capacitor upper electrode on the dielectric layer, and/or
in the sixth step, a capacitor is formed by forming the capacitor lower electrode in a portion of the second conductive layer, forming the dielectric layer so as to cover the upper surface or all of the capacitor lower electrode, and laminating the capacitor upper electrode on the dielectric layer.

### <First Modification>

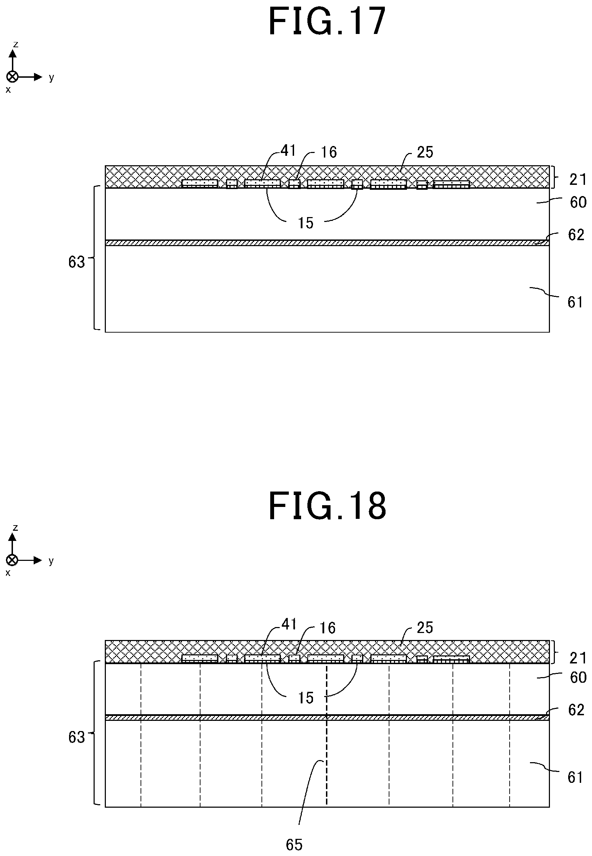

Hereinafter, a production method according to a first modification will be described with reference to Figs. 17 to 19.

The first modification differs from the first embodiment in that the formation step of the laser modified portions is performed after the formation step of the first wiring layer.

In the following description, the same or equivalent configurations as in the first embodiment described above will be denoted by like reference signs, and the description thereof will be simplified or omitted.

Fig. 17 is a cross-sectional view illustrating the formation step of the first wiring layer in the production method according to the first modification. In the first modification, the first wiring layer 21 is formed on the glass substrate 60 of the laminate structure 63 following the adhesion step of the first support body. At this time, a seed layer including the hydrofluoric acid resistant metal layer 15 is formed on the glass substrate 60, and then the through electrode connection portions 41 and the wiring 16 are formed by a semi-additive (SAP) method, and the insulating resin layer 25 is formed after removing the unnecessary seed layer.

Note that the materials and film formation methods of the hydrofluoric acid resistant metal layer and the through electrode connection portions are the same as those of the first embodiment.

### (Formation of Laser Modified Portions)

Next, a formation step of the laser modified portions in the first modification will be described with reference to Fig. 18. Fig. 18 is a cross-sectional view illustrating the formation step of laser modified portions in the production method according to the first modification. As shown here, the laser modified portions 65 are formed by irradiating the laminate structure 63 from the surface of the first support body 61.

In this step, because the laser modified portions are also formed along the singulation lines of the multilayer wiring substrate 1, it is possible to obtain the same shape as the side surface shape of the multilayer wiring substrate 1 described in the first embodiment.

### (Steps Following Adhesion of Second Support Body)

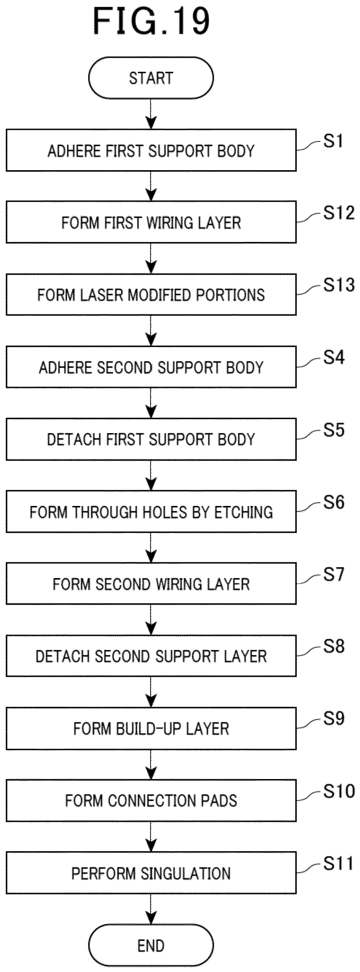

Fig. 19 is a diagram showing a flowchart of the production method according to the first modification. In the first modification, the steps other than the formation step of the first wiring layer (step S12) and the formation step of the laser modified portions (step S13) are the same as in the production method according to the first embodiment.

### <Second Modification>

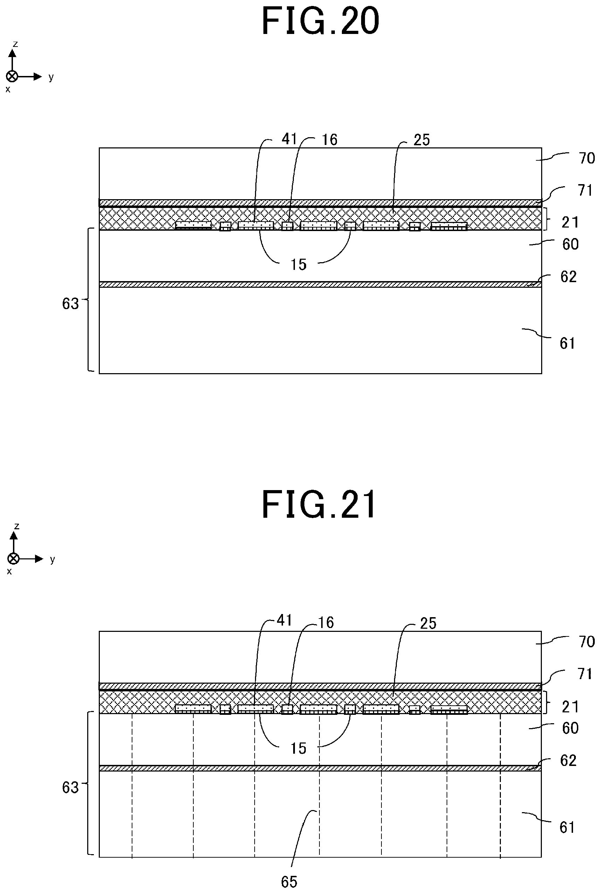

Hereinafter, a production method according to a second modification will be described with reference to Figs. 20 to 22.

The second modification differs from the first embodiment in that the laser modification step is performed after the adhesion step of the second support body.

In the following description, the same or equivalent configurations as in the first embodiment and the first modification described above will be denoted by like reference signs, and the description thereof will be simplified or omitted.

### (Adhesion of First Support Body and Formation of First Wiring Layer)

In the production method according to the second modification, because the adhesion step of the first support body, which is the first step, and the formation step of the first wiring layer are the same as the steps in the first embodiment, the description will be omitted.

### (Adhesion of Second Support Body)

Next, an adhesion step of the second support body in the second modification will be described with reference to Fig. 20. Fig. 20 is a cross-sectional view illustrating the adhesion step of the second support body in the production method according to the second modification. In the second modification, as shown here, the second adhesive layer 71 and the second support body 70 are formed on the first wiring layer 21 of the laminate structure 63.

### (Formation of Laser Modified Portions)

Fig. 21 is a cross-sectional view illustrating a formation step of laser modified portions in the production method according to the second modification. As shown here, the laser modified portions 65 are formed by irradiating the laminate structure 63 from the first support body 61 side.

In this step, because the laser modified portions are also formed along the singulation lines of the multilayer wiring substrate 1, it is possible to obtain the same shape as the side surface shape of the multilayer wiring substrate 1 described in the first embodiment.

### (Steps Following Detachment of First Support Body)

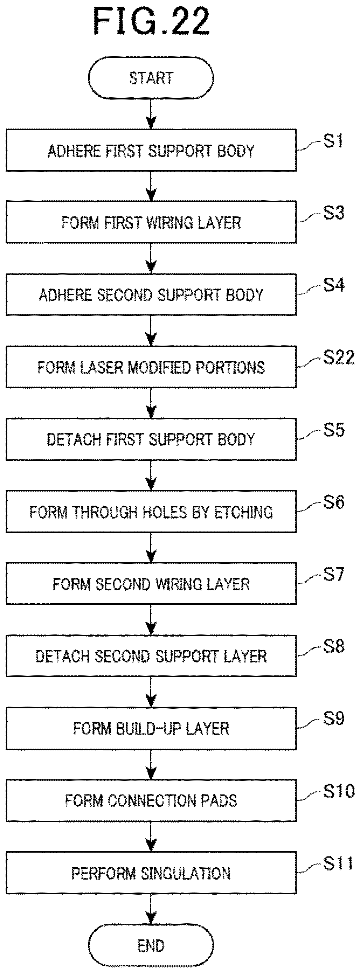

Fig. 22 is a diagram showing a flowchart of the production method according to the second modification. In the second modification, the production method is the same as the production method according to the first embodiment, except in that the order of the formation step of the laser modified portions (step S22) is different.

### <Actions and Effects>

According to the first embodiment, the first modification, and the second modification of the present invention, it is possible to avoid the occurrence of damage to the core substrate by protecting the side surface of the glass core laminate structure and the core substrate of the wiring substrate. Hereinafter, the details will be described using Examples and Comparative Examples. Note that the following Examples are merely examples of the present invention, and the present invention should not be construed as being limited to such embodiments.

### <Examples and Comparative Examples According to First Embodiment, and First and Second Modifications>

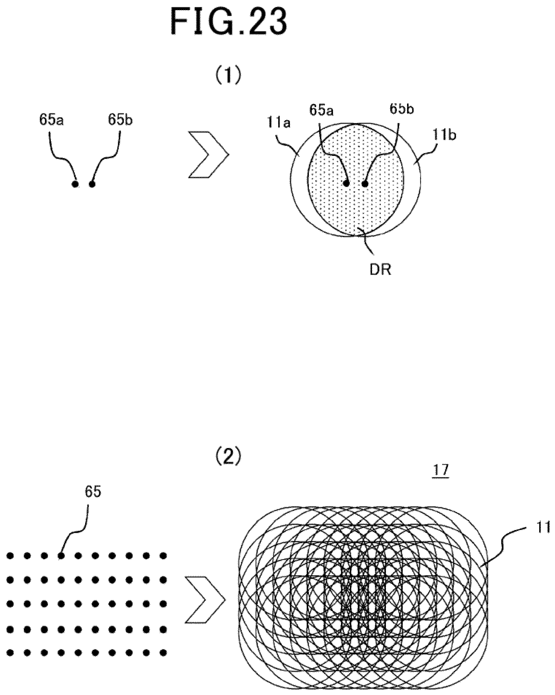

In the Examples and Comparative Examples, the implementation steps were performed such that the insulating resin on the side surface of the core substrate 10 of the multilayer wiring substrate was present or absent, and a temperature cycling test was carried out. Table 1 shows the production conditions, the overlap ratio of the through holes, and the spacing between the ridge lines in the Examples and Comparative Examples. In Examples 1 to 3, the processing pitch of the laser modified portions was changed, and the processing was carried out such that the overlap ratio of the through holes 11 of the glass substrate 60 formed by hydrofluoric acid etching was 40, 65, and 90%. Fig. 23 shown here is a diagram illustrating the overlap ratio of a laser modified portion 65 and a through hole 11. As shown in Fig. 23, the overlap ratio indicates the proportion in which a through hole 11 overlaps an adjacent through hole 11 when the through holes 11 are formed by hydrofluoric acid etching of the laser modified portion 65. As the overlap ratio increases, the proportion in which the through hole 11 overlaps the adjacent through hole increases. Fig. 23(1) is a diagram showing a case where there are two laser modified portions, and Fig. 23(2) is a diagram showing a case where a plurality of laser modified portions are formed and a separation groove is formed. As shown in Fig. 23(1), in the separation groove 17, a through hole 11a is formed with respect to the laser modified portion 65a, and a through hole 11b is formed with respect to the laser modified portion 65b. The overlapping region between the through hole 11a and the through hole 11b is represented by DR. The overlap ratio is the magnitude of the overlapping region DR with respect to the size of the through hole 11a or the size of the through hole 11b. As shown in Fig. 23(2), the separation groove 17 is formed as a result of the plurality of laser modified portions 65 and through holes 11 being formed.

In Comparative Example 1, the processing pitch of the laser modified portions in the separation groove 17 was set to a larger value than in Examples 1 to 3, and the processing was carried out such that the overlap ratio of the through holes 11 of the glass substrate 60 formed by hydrofluoric acid etching was 30%. In Comparative Example 2, the multilayer wiring substrate was produced without forming separation grooves, and singulation was performed by dicing processing after production. The Examples and Comparative Examples are shown in Table 1. Here, the spacing of the ridge lines represents that of the ridge lines generated in a perpendicular direction to the first surface 20 and the second surface 30 of the glass substrate 60, and it can be understood that the spacing of the ridge lines becomes wider as the overlap ratio decreases.

**[Table 1]**

| | Example 1 | Example 2 | Example 3 | Comparative Example 1 | Comparative Example 2 |
|---|---|---|---|---|---|
| Separation grooves | Yes | Yes | Yes | Yes | No |
| Separation groove formation method | Laser modification Hydrofluoric acid etching | | | | None |
| Overlap ratio | 40% | 65% | 90% | 30% | - |
| Spacing of ridge lines | 43.2 µm | 25.2 µm | 7.2 µm | 50.4 µm | - |

Next, the upper portion opening diameter, the bottom portion opening diameter, and the PV of the ridge lines of the dividing grooves of each Example and Comparative Example will be described using Table 2. Note that, in Table 2, the processing is performed such that the upper portion opening diameter of the dividing grooves is 300 um. As shown in Table 2, it can be seen that as the overlap ratio decreases and the spacing of the ridge lines increases, the average opening width of the bottom portion becomes smaller, and the variation (standard deviation) σ becomes larger. Furthermore, it was confirmed that as the overlap ratio decreases and the spacing of the ridge lines increases, the PV of the ridge lines increases, and the side surface of the separation groove becomes rougher. The above suggests that by setting the overlap ratio to be low and the spacing of the ridge lines to be large, the side surface of the separation grooves becomes rough, and the smoothness of the side surface of the separation grooves decreases.

**[Table 2]**

| | | Example 1 | Example 2 | Example 3 | Comparative Example 1 | Comparative Example 2 |
|---|---|---|---|---|---|---|
| Overlap ratio | | 40% | 65% | 90% | 30% | - |
| Spacing of ridge lines | | 43.2 µm | 25.2 µm | 7.2 µm | 50.4 µm | - |
| Opening width | Average | 290.4 µm | 293.1 µm | 296.3 µm | 283.2 µm | - |
| | Variation | 7.2 | 3.8 | 1.8 | 10.3 | - |
| Processing width of bottom portion | Average | 255.6 µm | 260.9 µm | 266.5 µm | 221.2 µm | - |
| | Variation | 8.5 | 4.5 | 1.9 | 12.4 | - |
| Processing width / opening width of bottom portion | | 0.88 | 0.89 | 0.9 | 0.78 | |
| PV of ridge lines | | 10.6 µm | 6.1 µm | 1.8 µm | 12.6 µm | < 0.1 µm |

Next, Table 3 shows the result of performing a temperature cycling test. As shown in Table 3, Comparative Example 1 passed the temperature cycling test to 500 cycles, but failed from 600 cycles onwards. Comparative Example 2 failed the temperature cycling test from 50 cycles onwards. In the case of a failure, defects such as the occurrence of fine cracks and the like were confirmed. Moreover, Examples 1, 2, and 3 passed the temperature cycling test even after 1,000 cycles. In Comparative Example 1, although the separation grooves are formed in the same manner as in Examples 1 to 3, as shown in Table 2, the PV of the ridge lines is large. For this reason, for example, it is plausible that failure of the temperature cycling test occurred in cases where, when performing singulation by dicing along the dividing grooves, the dicing blade partially made contact with the glass substrate 60, resulting in the occurrence of grinding marks, that is, microcracks, on the glass substrate 60.

The dicing process along the dividing grooves, the temperature cycling test conditions, and evaluation method were as follows.

### <Dicing Process>

Blade used: R07-SD600-BB200-75 54 × 0.15A2 × 40
Device used: DAD322

### <Temperature Cycling Test>

Test conditions: In one cycle, the temperature was changed from -55°C to RT (room temperature), and then to 125°C, while holding each temperature for 30 minutes, and the cycling was repeated to 1,000 cycles.

Observation method: The side surface of the substrate was observed with a metal microscope at magnifications of 100x and 500x to evaluate whether breakage of the glass substrate had occurred.

**[Table 3]**

| | | Example 1 | Example 2 | Example 3 | Comparative Example 1 | Comparative Example 2 |
|---|---|---|---|---|---|---|
| Separation grooves | | Yes | Yes | Yes | Yes | No |
| Separation groove formation method | | Laser modification | | | | None |
| | | Hydrofluoric acid etching | | | | |
| Overlap ratio | | 40% | 65% | 90% | 30% | - |
| Spacing of ridge lines | | 43.2 µm | 25.2 µm | 7.2 µm | 50.4 µm | - |
| PV of ridge lines | | 10.6 µm | 6.1 µm | 1.8 µm | 12.6 µm | - |
| Resin thickness of side surface of core substrate | | 52.8 µm | 55.5 µm | 58.9 µm | 35.6 µm | 0 µm |
| | 0 cycles | Passed | Passed | Passed | Passed | Passed |
| | 50 cycles | Passed | Passed | Passed | Passed | Passed |
| | 100 cycles | Passed | Passed | Passed | Passed | Failed |
| | 200 cycles | Passed | Passed | Passed | Passed | Failed |
| TCT test - 55 °C ↔ 125 °C | 300 cycles | Passed | Passed | Passed | Passed | Failed |
| | 400 cycles | Passed | Passed | Passed | Passed | Failed |
| | 500 cycles | Passed | Passed | Passed | Passed | Failed |
| | 600 cycles | Passed | Passed | Passed | Failed | Failed |
| | 700 cycles | Passed | Passed | Passed | Failed | Failed |
| | 800 cycles | Passed | Passed | Passed | Failed | Failed |
| | 900 cycles | Passed | Passed | Passed | Failed | Failed |
| | 1,000 cycles | Passed | Passed | Passed | Failed | Failed |

### <Application Examples>

Next, Application Examples of the embodiments of the present invention will be described using Table 4. In Table 4, when the number of singulation lines, which are separation grooves, and the spacing of the singulation lines in Example 3 was set to 1, the ratio of the number of singulation lines was set to 0.89, 1.11, and 1.22. Furthermore, the processing width of the opening portion and the bottom portion of the separation grooves, and the PV of the ridge lines in these cases are shown. Note that the same values as Example 3 are used for the overlap ratio. As can be understood from Table 4, by setting the modification line ratio to a high value, the processing width of the bottom portion improves, and it becomes possible to set the processing width / opening width of the bottom portion to a high value. In Application Examples 1 to 3, the opening width and the processing width of the bottom portion are larger than those in Examples 1 to 3, and even when a temperature cycling test is carried out after singulation, the same temperature cycling test as in Examples 1 to 3 was passed without a problem. This is considered to be because an effect has occurred that improves the adhesion between the insulating resin layer 25 of the second wiring layer 22 and the glass substrate 60.

**[Table 4]**

| | | Example 3 | Application Example 1 | Application Example 2 | Application Example 3 |
|---|---|---|---|---|---|
| Overlap ratio | | 90% | 90% | 90% | 90% |
| Spacing of ridge lines | | 7.2 µm | 7.5 µm | 6.9 µm | 7.2 µm |
| Ratio of number of singulation lines | | 1.0 | 0.89 | 1.11 | 1.22 |
| Opening width | Average | 296.3 µm | 295.8 µm | 296.8 µm | 297.3 µm |
| | Variation | 1.8 | 1.2 | 1.1 | 1.0 |
| Processing width of bottom portion | Average | 266.5 µm | 257.3 µm | 291.3 µm | 296.4 µm |
| | Variation | 1.9 | 1.5 | 1.4 | 1.1 |
| Processing width / opening width of bottom portion | | 0.9 | 0.87 | 0.98 | 1.0 |
| PV of ridge lines | | 1.8 µm | 2.1 µm | 1.7 µm | 1.8 µm |

From the Examples and Application Examples described above, it is preferable that the overlap ratio is 40% or more and 90% or less, the resin thickness of the side surface of the core substrate is 52.8 µm or more, the processing width / opening width of the bottom portion is 0.88 or more, and the PV of the ridge lines is 1.8 µm or more and 10.6 µm or less.

### <Second Embodiment>

A second differs from the first embodiment in that an inductor is formed in the first wiring layer.

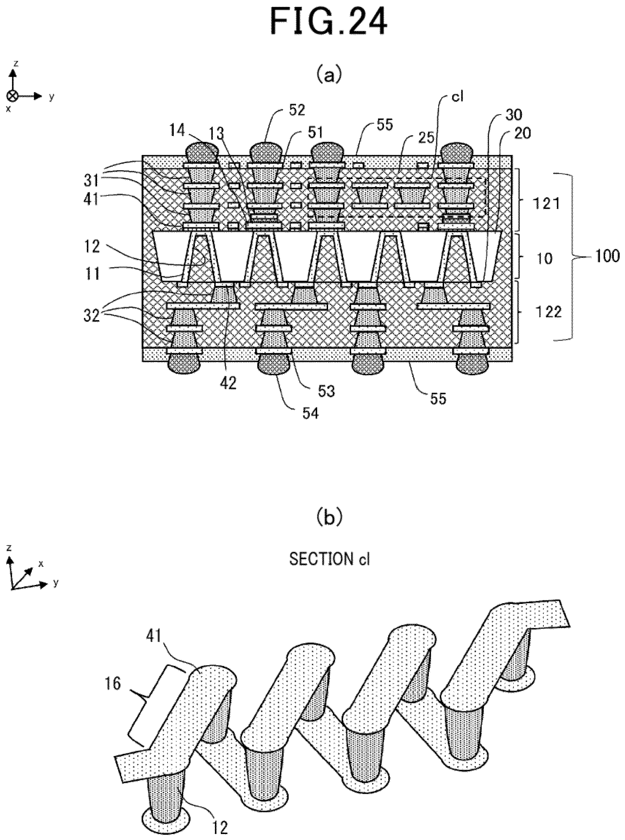

Fig. 24 is a cross-sectional view showing a multilayer wiring substrate 100 according to the second embodiment. In the following description, the same or equivalent configurations as in the first embodiment described above will be denoted by like reference signs, and the description will be simplified or omitted.

The first wiring layer 121 is formed of three wiring layers, and the second wiring layer 122 is also formed of three wiring layers. Fig. 24(b) is a perspective view of circuit elements that are in the section cl enclosed by the dash dotted line in Fig. 24(a). As shown here, an LC resonant circuit is formed by connecting at least one of the capacitors and at least one of the inductors. Specifically, adjacent conductive electrodes 31 are connected via the through electrode connection portions 41 and the wiring 16, and integrally form a coil. The coil is connected to, for example, the capacitor electrodes 13 to exhibit the characteristics as an LC circuit.

In the production method, in the formation step of the first wiring layer, the arrangement of the through electrode connection portions 41 and the wiring 16 is set so as to form inductors.

### <Actions and Effects>

As a result of protecting the side surface of the core substrate 10 with the insulating resin, it becomes possible to obtain a high reliability. Furthermore, because the inductors are provided in the multilayer wiring substrate 100, the wiring distance can be shortened, and good transmission characteristics can be obtained.

### <Other Aspects>

The present disclosure includes the following aspects.

### (Aspect 1)

A multilayer wiring substrate comprising:
a core substrate having a first surface and a second surface opposing the first surface;
a first wiring layer, being a wiring layer formed on the first surface; and
a second wiring layer, being a wiring layer formed on the second surface; wherein
at least a side surface of the core substrate is covered with an insulating resin.

### (Aspect 2)

The multilayer wiring substrate according to aspect 1, wherein
the core substrate is formed having a through hole that penetrates from the first surface to the second surface, and a through electrode that electrically connects the first surface and the second surface through the through hole, and
the first wiring layer has a first conductive portion disposed therein that connects to the through electrode, the second wiring layer has a second conductive portion disposed therein that connects to the through electrode, and the first conductive portion and the second conductive portion are electrically connected through the through electrode.

### (Aspect 3)

The multilayer wiring substrate according to aspect 1 or 2, wherein
the first wiring layer and the second wiring layer include an insulating resin layer, and
the insulating resin is the same type of insulating resin as an insulating resin forming the insulating resin layer.

### (Aspect 4)

The multilayer wiring substrate according to any one of aspects 1 to 3, wherein
a thickness of the insulating resin that covers the side surface of the core substrate is 50 µm or more,
a thickness of the core substrate is included in a range of 50 µm or more and 150 µm or less, and
the insulating resin has a relative dielectric constant included in a range of 3.1 or more and 3.5 or less, and a dielectric loss tangent included in a range of 0.002 or more and 0.012 or less.

### (Aspect 5)

The multilayer wiring substrate according to any one of aspects 1 to 4, wherein
the side surface of the core substrate has a plurality of recessed portions having a substantially rectangular shape that consist of a plurality of vertical ridge lines and horizontal ridge lines, and a horizontal direction dimension of the rectangle is 5 µm or more and 20 µm or less, and a vertical direction dimension is 2 µm or more and 25 µm or less.

### (Aspect 6)

The multilayer wiring substrate according to any one of aspects 1 to 5, wherein
a PV of the ridge lines is 1.8 µm or more and 10.6 µm or less.

### (Aspect 7)

The multilayer wiring substrate according to any one of aspects 1 to 6, wherein
a depth of the plurality of recessed portions is 0.5 µm or more and 11 µm or less.

### (Aspect 8)

The multilayer wiring substrate according to any one of aspects 1 to 7, wherein
a resin thickness of the side surface of the core substrate is 52.8 µm or less.

### (Aspect 9)

A production method for a multilayer wiring substrate that produces a multilayer wiring substrate using a base material substrate having a first surface, and a second surface opposing the first surface, the method comprising:
a first step of adhering a support body to the second surface, among the first surface and the second surface of the base material substrate;
a second step of forming a modified portion at a through hole position, being a position in which a through hole that penetrates from the first surface to the second surface is formed, and a singulation line position, which represents a position of a separation groove that causes the multilayer wiring substrate to be separated from the base material substrate, by irradiating a laser from a first surface side of the base material substrate;
a third step of forming a first conductive portion on the first surface side, and forming a first wiring layer by depositing a resin member;
a fourth step of detaching the support body from the base material substrate;
a fifth step of removing the modified portion from a second surface side by etching, and forming the through hole and the separation groove;
a sixth step of introducing a conductive member to the through hole from the second surface side, and forming a through electrode that electrically connects the first conductive portion and the second surface;
a seventh step of depositing the same type of insulating resin as the resin member on the second surface side, and forming a second wiring layer on the second surface; and
an eighth step of performing singulation along the separation groove, and separating the multilayer wiring substrate.

### (Aspect 10)

The production method for a multilayer wiring substrate according to aspect 9, wherein
a side surface of the multilayer wiring substrate following singulation is covered with the insulating resin.

### (Aspect 11)

The production method for a multilayer wiring substrate according to aspect 9 or 10, wherein
in the fifth step, a thickness of the base material substrate due to etching is in a range of 50 µm or more and 150 µm or less,
a thickness of the insulating resin covering a side surface of the multilayer wiring substrate is 50 µm or more, and
the insulating resin has a relative dielectric constant included in a range of 3.1 or more and 3.5 or less, and a dielectric loss tangent included in a range of 0.002 or more and 0.012 or less.

### (Aspect 12)

The production method for a multilayer wiring substrate according to any one of aspects 9 to 11, wherein
in the second step, an overlap ratio of the through hole in the separation groove is 40% or more and 90% or less.

### (Aspect 13)

The production method for a multilayer wiring substrate according to any one of aspects 9 to 12, wherein
in the second step, a processing width / opening width of a bottom portion of the through hole in the separation groove is 0.88 or more.

### (Aspect 14)

A base material substrate having a first surface and a second surface, and containing a plurality of multilayer wiring substrates, the base material substrate comprising:
a first wiring layer, being a wiring layer formed on the first surface;
a second wiring layer, being a wiring layer formed on the second surface; and
a separation groove used for performing singulation of the plurality of multilayer wiring substrates; wherein
the separation groove is filled with an insulating resin.

The scope of the present invention is not limited to the exemplary embodiments that have been illustrated and described, and includes various modifications. For example, the embodiments described above have been described in detail to facilitate understanding of the present invention, and the present invention is not necessarily limited to having all of the configurations that have been described.

Furthermore, it is possible to replace a portion of the configuration of a certain embodiment with the configuration of another embodiment, and further, it is possible to add the configuration of another embodiment to the configuration of the certain embodiment. In addition, a portion of the configuration of each embodiment can be added, deleted, or replaced with other configurations.

Also, the present invention also includes all embodiments that provide effects equivalent to those intended by the present invention.

For example, the present disclosure discloses that the laser modified portions are formed after adhering the first support body to the glass substrate, and then detaching the first support body, but it is not limited to this. For example, the laser modified portions may be formed without using the first support body, and the laser modified portions may be etched to a desired thickness in the through hole formation step.

### [Reference Signs List]

1, 100: Multilayer wiring substrate,
10: Core substrate
11: Through hole,
12: Through electrode,
13: Capacitor electrode,
14: Dielectric layer,
15: Hydrofluoric acid resistant metal layer,
16: Wiring,
17: Separation groove,
17T: Opening width of separation groove,
17B: Processing width of bottom portion of separation groove,
21; 121: First wiring layer,
22; 122: Second wiring layer,
25: Insulating resin layer,
31; 32: Conductive electrode,
41; 42: Through electrode connection portion
51: Semiconductor element bonding pad,
52: Semiconductor element bonding solder,
53: Substrate bonding pad,
54: Substrate bonding solder,
55: Solder resist,
60: Glass substrate,
61: First support body,
62: First adhesive layer,
63: Laminate structure,
65; 65a; 65b: Laser modified portion,
65T: Transfer marks of laser modified portion,
70: Second support body,
71: Second adhesive layer,
72: Blade.

## Claims

1. A glass core laminate structure (1) comprising:
a glass core substrate (60) having a first surface (20), and a second surface (30) opposing the first surface; and
a laminate including, above the first surface (20) and below the second surface (30), a layer (25) formed of a material different from that of the glass core substrate (60); wherein
a side surface of the glass core laminate structure (60) is covered with the same material as one material forming the laminate, and
the glass core laminate structure (1) being **characterized in that**
a plurality of recessed portions having a substantially rectangular shape, through which a plurality of vertical ridge lines and horizontal ridge lines can be visually recognized, are formed on at least a portion of the side surface of the glass core substrate (60).

2. The glass core laminate structure (1) according to claim 1, wherein
in the plurality of recessed portions
a spacing (R1) between vertical ridge lines is 5 µm or more and 20 µm or less, and
a spacing between horizontal ridge lines is 2 µm or more and 25 µm or less.

3. The glass core laminate structure (1) according to claim 1, wherein
a PV value of the vertical ridge lines and the horizontal ridge lines is 1.8 µm or more and 10.6 µm or less.

4. The glass core laminate structure (1) according to claim 1, wherein
a depth of the plurality of recessed portions is 0.5 µm or more and 11 µm or less.

5. The glass core laminate structure (1) according to any one of claims 1 to 4, wherein
the glass core substrate (60) has a plurality of through holes (11) that penetrate from the first surface (20) to the second surface (30),
at least some of the plurality of through holes (11) are through electrodes (12) formed by laminating a conductive layer on an inner wall thereof,
the glass core substrate (60) includes
a first wiring layer (21) containing a conductor on the first surface (20), and
a second wiring layer (22) containing a conductor on the second surface (30), and
the first wiring layer (21) and the second wiring layer (22) are electrically connected by the through electrodes (12).

6. The glass core laminate structure (1)according to claim 5, wherein
a first insulating resin layer (25) is laminated and disposed on the first wiring layer (21), a second insulating resin layer (25) is laminated and disposed on the second wiring layer (22),
an inside of the through electrodes (11) is filled by an insulating resin extending from the first insulating resin layer or the second insulating resin layer (25), and
a side surface of the glass core laminate structure (1) is covered with the insulating resin extending from the first insulating resin layer or the second insulating resin layer (25).

7. The glass core laminate structure (1) according to claim 6, wherein
a wiring layer and an insulating layer are further alternately laminated one or more times on the first insulating resin layer (25),
a wiring layer and an insulating layer are further alternately laminated one or more times on the second insulating resin layer (25), and
as a result of through electrodes provided inside the insulating layers that have been laminated a plurality of times, the wiring layers above and below are electrically connected.

8. The glass core laminate structure (1) according to claim 7, wherein
a portion of the wiring layer is a lower electrode (41),
a dielectric layer (14) is laminated on the wiring layer so as to cover part or all of an upper surface of the lower electrode (41),
a capacitor is formed by disposing an upper electrode (13) on the dielectric layer (14) so as to cover part or all of the dielectric layer in a plan view, cover part or all of the lower electrode, and not be electrically connected to the lower electrode, and
the dielectric layer (14) and the upper electrode (13) are disposed within a thickness direction range of an insulating layer disposed between a conductive layer including the lower electrode (41) and a conductive layer formed directly thereabove.

9. The glass core laminate structure (1) according to claim 8, wherein
an inductor is formed by
connecting a portion of wiring (41) of the wiring layer, or
connecting a portion of wiring (41) of the wiring layer and a through electrode (12).

10. The glass core laminate structure (1) according to claim 9, wherein
an LC resonant circuit is formed by connecting at least one capacitor and at least one inductor.

## Patentansprüche

1. Glaskernlaminatstruktur (1), umfassend:
ein Glaskernsubstrat (60) mit einer ersten Oberfläche (20) und einer zweiten Oberfläche (30), die der ersten Oberfläche gegenüberliegt; und
ein Laminat, das oberhalb der ersten Oberfläche (20) und unterhalb der zweiten Oberfläche (30) eine Schicht (25) aufweist, die aus einem Material gebildet ist, das sich von dem des Glaskernsubstrats (60) unterscheidet; wobei
eine Seitenfläche der Glaskernlaminatstruktur (60) mit demselben Material wie einem das Laminat bildenden Material bedeckt ist, und
die Glaskernlaminatstruktur (1) **dadurch gekennzeichnet ist, dass**
eine Mehrzahl von vertieften Abschnitten mit einer im Wesentlichen rechteckigen Form, durch die eine Mehrzahl von vertikalen Gratlinien und horizontalen Gratlinien visuell erkannt werden kann, auf mindestens einem Teil der Seitenfläche des Glaskernsubstrats (60) ausgebildet ist.

2. Glaskernlaminatstruktur (1) gemäß Anspruch 1, wobei
in der Mehrzahl von vertieften Abschnitten
ein Abstand (RI) zwischen vertikalen Gratlinien 5 µm oder mehr und 20 µm oder weniger beträgt, und
ein Abstand zwischen horizontalen Gratlinien 2 µm oder mehr und 25 µm oder weniger beträgt.

3. Glaskernlaminatstruktur (1) gemäß Anspruch 1, wobei ein PV-Wert der vertikalen Gratlinien und der horizontalen Gratlinien 1,8 µm oder mehr und 10,6 µm oder weniger beträgt.

4. Glaskernlaminatstruktur (1) gemäß Anspruch 1, wobei
eine Tiefe der Mehrzahl von vertieften Abschnitten 0,5 µm oder mehr und 11 µm oder weniger beträgt.

5. Glaskernlaminatstruktur (1) gemäß einem der Ansprüche 1 bis 4, wobei
das Glaskernsubstrat (60) eine Mehrzahl von Durchgangslöchern (11) aufweist, die von der ersten Oberfläche (20) zur zweiten Oberfläche (30) durchdringen,
mindestens einige der Mehrzahl von Durchgangslöchern (11) Durchgangselektroden (12) sind, die durch Laminieren einer leitfähigen Schicht auf einer Innenwandung davon gebildet sind,
das Glaskernsubstrat (60) umfasst:
eine erste Verdrahtungsschicht (21), die einen Leiter auf der ersten Oberfläche (20) enthält, und
eine zweite Verdrahtungsschicht (22), die einen Leiter auf der zweiten Oberfläche (30) enthält, und wobei
die erste Verdrahtungsschicht (21) und die zweite Verdrahtungsschicht (22) durch die Durchgangselektroden (12) elektrisch verbunden sind.

6. Glaskernlaminatstruktur (1) gemäß Anspruch 5, wobei
eine erste isolierende Harzschicht (25) auf der ersten Verdrahtungsschicht (21) laminiert und angeordnet ist,
eine zweite isolierende Harzschicht (25) auf der zweiten Verdrahtungsschicht (22) laminiert und angeordnet ist,
ein Inneres der Durchgangselektroden (11) durch ein isolierendes Harz gefüllt ist, das sich von der ersten isolierenden Harzschicht oder der zweiten isolierenden Harzschicht (25) erstreckt, und
eine Seitenfläche der Glaskernlaminatstruktur (1) mit dem isolierenden Harz bedeckt ist, das sich von der ersten isolierenden Harzschicht oder der zweiten isolierenden Harzschicht (25) erstreckt.

7. Glaskernlaminatstruktur (1) gemäß Anspruch 6, wobei
eine Verdrahtungsschicht und eine Isolierschicht auf der ersten isolierenden Harzschicht (25) ferner ein- oder mehrmals alternierend laminiert sind,
eine Verdrahtungsschicht und eine Isolierschicht auf der zweiten isolierenden Harzschicht (25) ferner ein- oder mehrmals alternierend laminiert sind, und
infolge von Durchgangselektroden, die innerhalb der mehrfach laminierten Isolierschichten vorgesehen sind, die darüber und darunter liegenden Verdrahtungsschichten elektrisch verbunden sind.

8. Glaskernlaminatstruktur (1) gemäß Anspruch 7, wobei ein Abschnitt der Verdrahtungsschicht eine untere Elektrode (41) ist, eine dielektrische Schicht (14) auf der Verdrahtungsschicht so laminiert ist, dass sie einen Teil oder die gesamte obere Oberfläche der unteren Elektrode (41) bedeckt,
ein Kondensator durch Anordnen einer oberen Elektrode (13) auf der dielektrischen Schicht (14) so gebildet ist, dass sie in einer Draufsicht einen Teil oder die gesamte dielektrische Schicht bedeckt, einen Teil oder die gesamte untere Elektrode bedeckt und nicht elektrisch mit der unteren Elektrode verbunden ist, und
die dielektrische Schicht (14) und die obere Elektrode (13) innerhalb eines Dickenrichtungsbereichs einer Isolierschicht angeordnet sind, die zwischen einer leitfähigen Schicht, die die untere Elektrode (41) enthält, und einer unmittelbar darüber gebildeten leitfähigen Schicht angeordnet ist.

9. Glaskernlaminatstruktur (1) gemäß Anspruch 8, wobei ein Induktor gebildet ist durch
Verbinden eines Abschnitts einer Verdrahtung (41) der Verdrahtungsschicht, oder
Verbinden eines Abschnitts einer Verdrahtung (41) der Verdrahtungsschicht und einer Durchgangselektrode (12).

10. Glaskernlaminatstruktur (1) gemäß Anspruch 9, wobei
ein LC-Schwingkreis durch Verbinden mindestens eines Kondensators und mindestens eines Induktors gebildet ist.

## Revendications

1. Structure stratifiée à noyau de verre (1) comprenant :
un substrat à noyau de verre (60) ayant une première surface (20) et une seconde surface (30) opposée à la première surface ; et
un stratifié comportant, au-dessus de la première surface (20) et au-dessous de la seconde surface (30), une couche (25) constituée d'un matériau différent de celui du substrat à noyau de verre (60) ; dans laquelle
une surface latérale de la structure stratifiée à noyau de verre (60) est recouverte du même matériau qu'un matériau formant le stratifié, et
la structure stratifiée à noyau de verre (1) étant **caractérisée en ce que**
une pluralité de portions en retrait ayant une forme sensiblement rectangulaire, par lesquelles une pluralité de lignes de crête verticales et de lignes de crête horizontales peuvent être reconnues visuellement, sont formées sur au moins une portion de la surface latérale du substrat à noyau de verre (60).

2. Structure stratifiée à noyau de verre (1) selon la revendication 1, dans laquelle dans la pluralité de portions en retrait
un espacement (R1) entre les lignes de crête verticales est de 5 µm ou plus et de 20 µm ou moins, et
un espacement entre les lignes de crête horizontales est de 2 µm ou plus et de 25 µm ou moins.

3. Structure stratifiée à noyau de verre (1) selon la revendication 1, dans laquelle
une valeur PV des lignes de crête verticales et des lignes de crête horizontales est de 1,8 µm ou plus et de 10,6 µm ou moins.

4. Structure stratifiée à noyau de verre (1) selon la revendication 1, dans laquelle une profondeur de la pluralité de portions en retrait est de 0,5 µm ou plus et de 11 µm ou moins.

5. Structure stratifiée à noyau de verre (1) selon l'une quelconque des revendications 1 à 4, dans laquelle
le substrat à noyau de verre (60) a une pluralité de trous traversants (11) qui pénètrent à partir de la première surface (20) jusqu'à la seconde surface (30),
au moins certains de la pluralité de trous traversants (11) sont des électrodes traversantes (12) formées par stratification d'une couche conductrice sur une paroi intérieure de ceux-ci,
le substrat à noyau de verre (60) comporte
une première couche de câblage (21) contenant un conducteur sur la première surface (20), et
une seconde couche de câblage (22) contenant un conducteur sur la seconde surface (30), et
la première couche de câblage (21) et la seconde couche de câblage (22) sont reliées électriquement par les électrodes traversantes (12).

6. Structure stratifiée à noyau de verre (1) selon la revendication 5, dans laquelle
une première couche de résine isolante (25) est stratifiée et disposée sur la première couche de câblage (21),
une seconde couche de résine isolante (25) est stratifiée et disposée sur la seconde couche de câblage (22),
un intérieur des électrodes traversantes (11) est rempli d'une résine isolante s'étendant à partir de la première couche de résine isolante ou de la seconde couche de résine isolante (25), et
une surface latérale de la structure stratifiée à noyau de verre (1) est recouverte de la résine isolante s'étendant à partir de la première couche de résine isolante ou de la seconde couche de résine isolante (25).

7. Structure stratifiée à noyau de verre (1) selon la revendication 6, dans laquelle
une couche de câblage et une couche isolante sont en outre stratifiées alternativement une ou plusieurs fois sur la première couche de résine isolante (25),
une couche de câblage et une couche isolante sont en outre stratifiées alternativement une ou plusieurs fois sur la seconde couche de résine isolante (25), et
puisque des électrodes traversantes prévues dans les couches isolantes ont été stratifiées une pluralité de fois, les couches de câblage au-dessus et au-dessous sont connectées électriquement.

8. Structure stratifiée à noyau de verre (1) selon la revendication 7, dans laquelle une portion de la couche de câblage est une électrode inférieure (41),
une couche diélectrique (14) est stratifiée sur la couche de câblage de manière à recouvrir une partie ou la totalité d'une surface supérieure de l'électrode inférieure (41),
un condensateur est formé en disposant une électrode supérieure (13) sur la couche diélectrique (14) de manière à recouvrir une partie ou la totalité de la couche diélectrique dans une vue en plan, recouvrir une partie ou la totalité de l'électrode inférieure, et ne pas être connectée électriquement à l'électrode inférieure, et
la couche diélectrique (14) et l'électrode supérieure (13) sont disposées dans une plage de direction d'épaisseur d'une couche isolante disposée entre une couche conductrice comportant l'électrode inférieure (41) et une couche conductrice formée directement au-dessus de celle-ci.

9. Structure stratifiée à noyau de verre (1) selon la revendication 8, dans laquelle un inducteur est formé par
la connexion d'une portion de câblage (41) de la couche de câblage, ou
la connexion d'une portion de câblage (41) de la couche de câblage et d'une électrode traversante (12).

10. Structure stratifiée à noyau de verre (1) selon la revendication 9, dans laquelle
un circuit résonant LC est formé en connectant au moins un condensateur et au moins un inducteur.
